(19) Europäisches Patentamt
European Patent Office
Office européen des brevets

(11) **EP 4 492 533 A1**

(12) **EUROPEAN PATENT APPLICATION**
published in accordance with Art. 153(4) EPC

(43) Date of publication:
**15.01.2025 Bulletin 2025/03**

(21) Application number: **22930987.7**

(22) Date of filing: **29.09.2022**

(51) International Patent Classification (IPC):
*H01M 10/48* (2006.01)

(52) Cooperative Patent Classification (CPC):
**G01R 31/367; G01R 31/3842; G01R 31/388;
G01R 31/389; G01R 31/392; G01R 31/396;
H01M 10/42; H01M 10/48;** Y02E 60/10

(86) International application number:
**PCT/JP2022/036382**

(87) International publication number:
**WO 2023/171010 (14.09.2023 Gazette 2023/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.03.2022 US 202263317226 P**

(71) Applicant: **Nuvoton Technology Corporation
Japan
Nagaokakyo City, Kyoto 617-8520 (JP)**

(72) Inventors:
• **MITSUOKA, Misaki
Nagaokakyo City, Kyoto 617-8520 (JP)**
• **KOBAYASHI, Hitoshi
Nagaokakyo City, Kyoto 617-8520 (JP)**
• **FUJII, Keiichi
Nagaokakyo City, Kyoto 617-8520 (JP)**
• **KAWABE, Akira
Nagaokakyo City, Kyoto 617-8520 (JP)**
• **KATO, Takumi
Nagaokakyo City, Kyoto 617-8520 (JP)**

(74) Representative: **Novagraaf International SA
Chemin de l'Echo 3
1213 Onex, Geneva (CH)**

(54) **BATTERY PACK MANAGEMENT SYSTEM AND BATTERY PACK MANAGEMENT METHOD**

(57) A battery pack management system that manages a battery pack (1) of storage batteries (BO through B7) connected in series or parallel, includes: an acquisition unit (for example, a model parameter expander (301)) that acquires respective impedances of the storage batteries (BO through B7) corresponding to a first time point; and a generator (for example, an ID converter (4)) that generates identification information of the battery pack (1) based on the acquired impedances of the storage batteries (BO through B7).

FIG. 1

EP 4 492 533 A1

**Description**

[Technical Field]

The present disclosure relates to a battery pack management system and a battery pack management method.

[Background Art]

Applications that use secondary batteries, such as electric vehicles and storage batteries, have been increasing rapidly. Lithium-ion batteries (LiBs) are used as secondary batteries, for example. In such LiBs, measurement of electrical characteristics of the battery is performed for management and performance awareness (degradation awareness). For example, Patent Literature (PTL) 1 discloses a device that uses an alternating current (AC) impedance method for measuring voltage and current while causing a battery to sweep an AC signal, to sort and manage batteries according to their characteristics.

[Citation List]

[Patent Literature]

[PTL 1] Japanese Unexamined Patent Application Publication No. 2013-170862

[Summary of Invention]

[Technical Problem]

With the extension of the life cycle through reuse of LiBs, there are concerns about the occurrence of security risks such as falsification of battery residual value information, theft of hardware, and mixing of counterfeit products. Therefore, it is desirable to reduce such security risks, but PTL 1 is silent in regard to reducing security risks.

In view of this, the present disclosure provides a battery pack management system and a battery pack management method that can reduce security risks.

[Solution to Problem]

A battery pack management system according to one aspect of the present disclosure manages a battery pack of storage batteries connected in series or parallel, and includes: a first acquisition unit configured to acquire respective first impedances of the storage batteries corresponding to a first time point; and a generator that generates first identification information of the battery pack based on the first impedances of the storage batteries acquired.

A battery pack management method according to one aspect of the present disclosure is a method of managing a battery pack of storage batteries connected in series or parallel, and includes: acquiring respective impedances of the storage batteries corresponding to a first time point; and generating identification information of the battery pack based on the impedances of the storage batteries acquired.

[Advantageous Effects of Invention]

With the battery pack management system and the like according to one aspect of the present disclosure, security risks can be reduced.

[Brief Description of Drawings]

[FIG. 1]

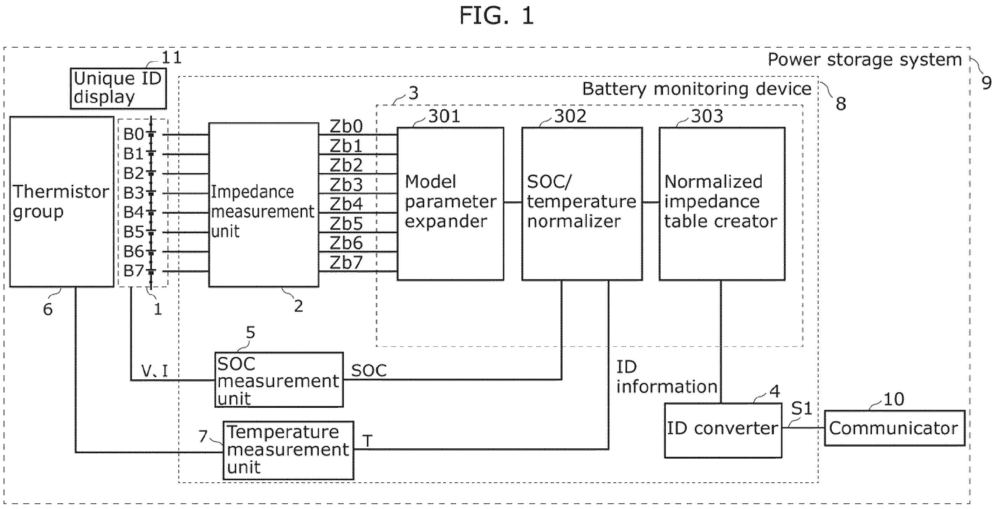

FIG. 1 is a block diagram illustrating the functional configuration of a power storage system according to Embodiment 1.
[FIG. 2]

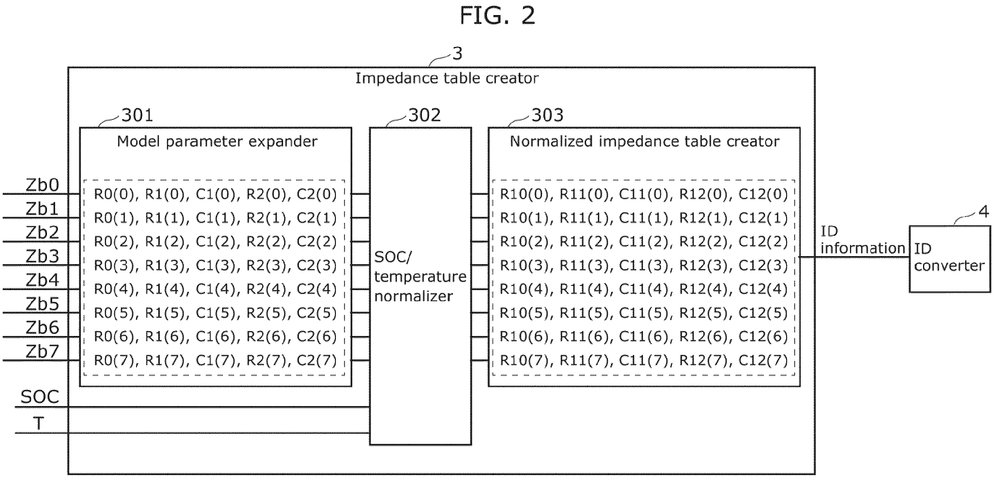

FIG. 2 is a block diagram illustrating the functional configuration of an impedance table creator according to Embodiment 1.
[FIG. 3A]

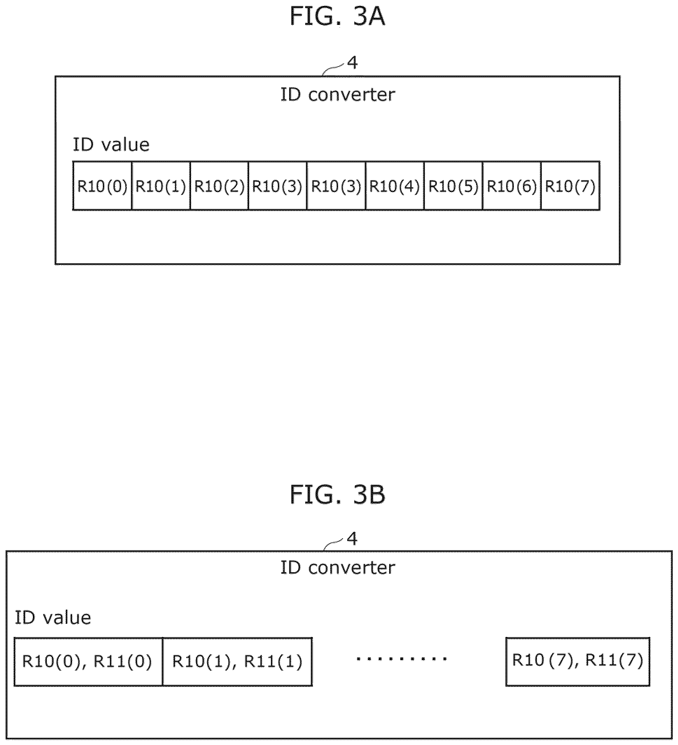

FIG. 3A illustrates an example of an ID value generated by an ID converter according to Embodiment 1.

[FIG. 3B]

FIG. 3B illustrates another example of an ID value generated by the ID converter according to Embodiment 1.

[FIG. 4A]

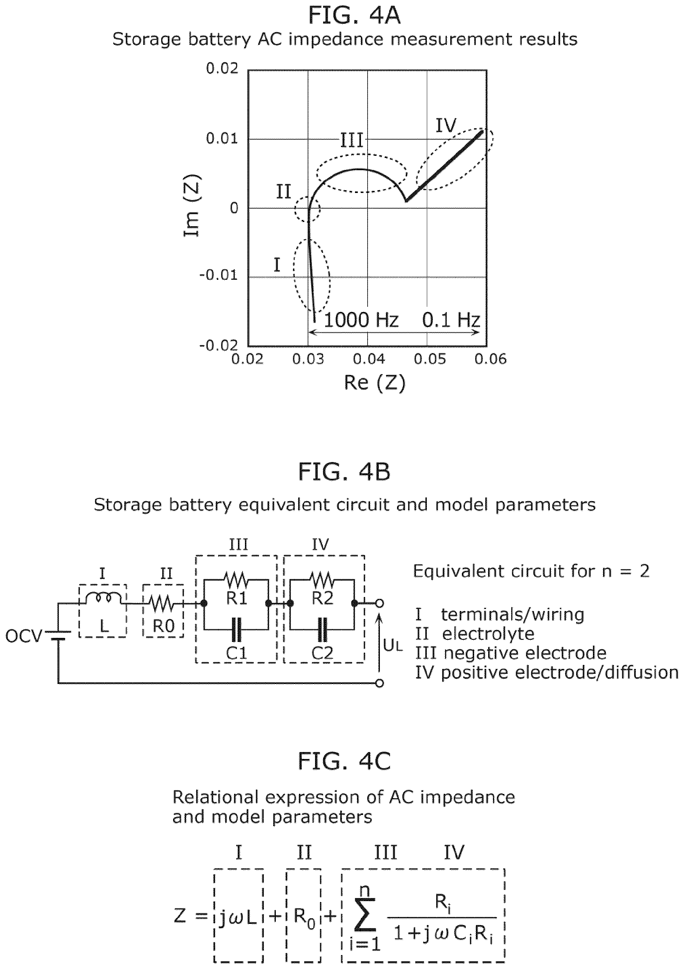

FIG. 4A illustrates an example of AC impedance measurement results of a storage battery according to Embodiment 1.

[FIG. 4B]

FIG. 4B illustrates one example of a battery model that is the equivalent circuit of the storage battery according to Embodiment 1.

[FIG. 4C]

FIG. 4C is a relational expression of AC impedances and model parameters according to Embodiment 1.

[FIG. 5A]

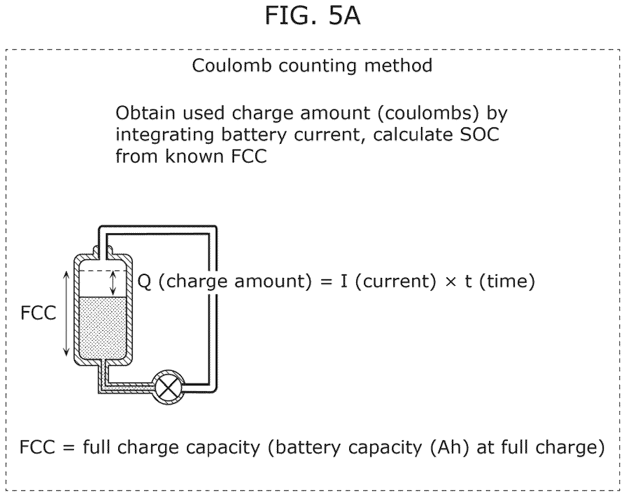

FIG. 5A is for explaining the coulomb counting method, which is one example of a method for calculating the state of charge.

[FIG. 5B]

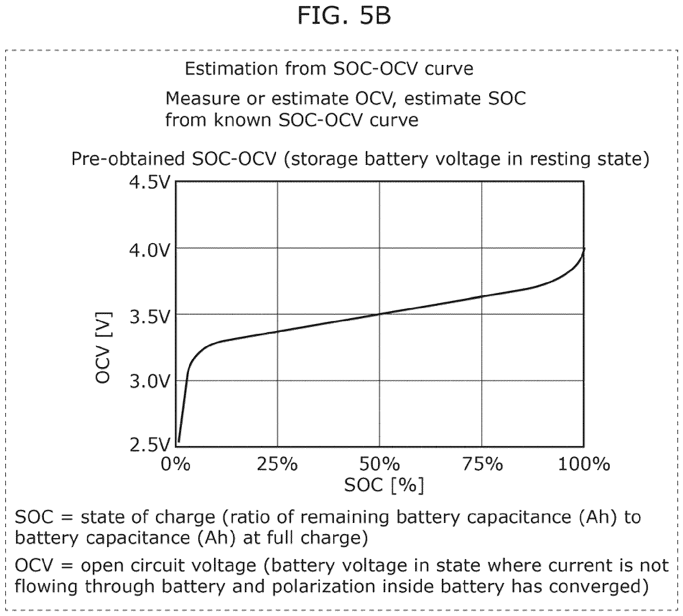

FIG. 5B is for explaining an estimation method from the SOC-OCV curve, which is another example of a method for calculating the state of charge.

[FIG. 6A]

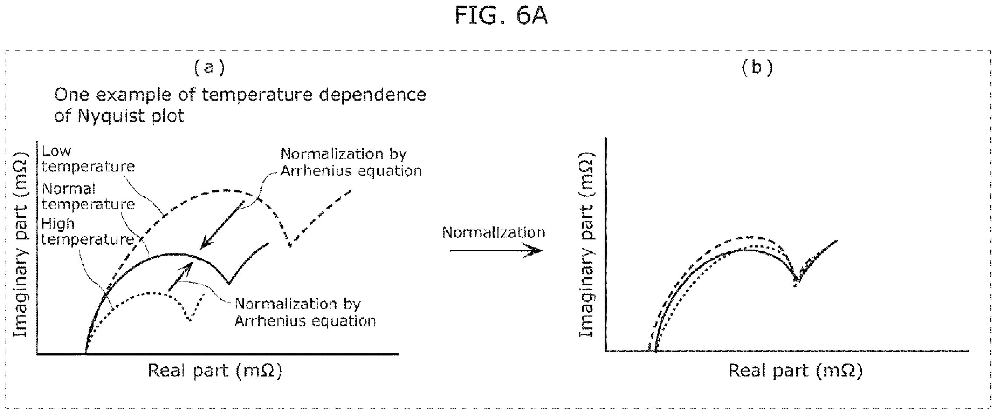

FIG. 6A is for explaining an example of normalization of a Nyquist plot of impedance of a storage battery with temperature as a parameter.

[FIG. 6B]

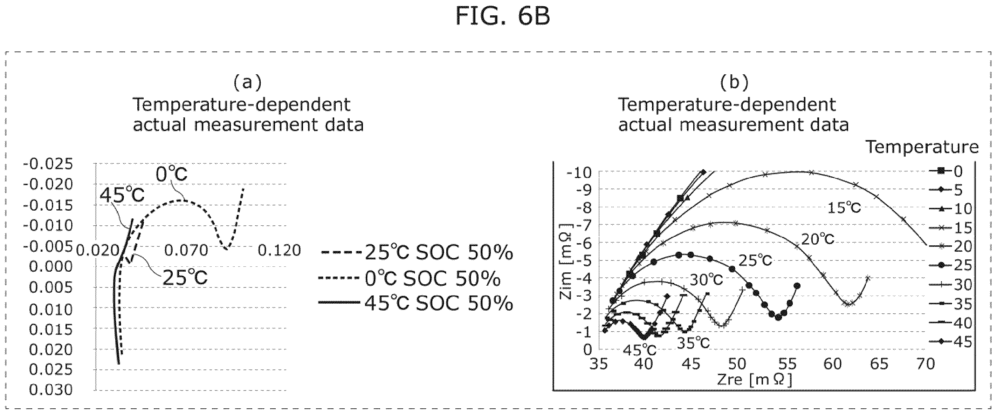

FIG. 6B is a diagram illustrating the results of performing normalization of a Nyquist plot of impedance of a storage battery with temperature as a parameter on actual measurement data.

[FIG. 7]

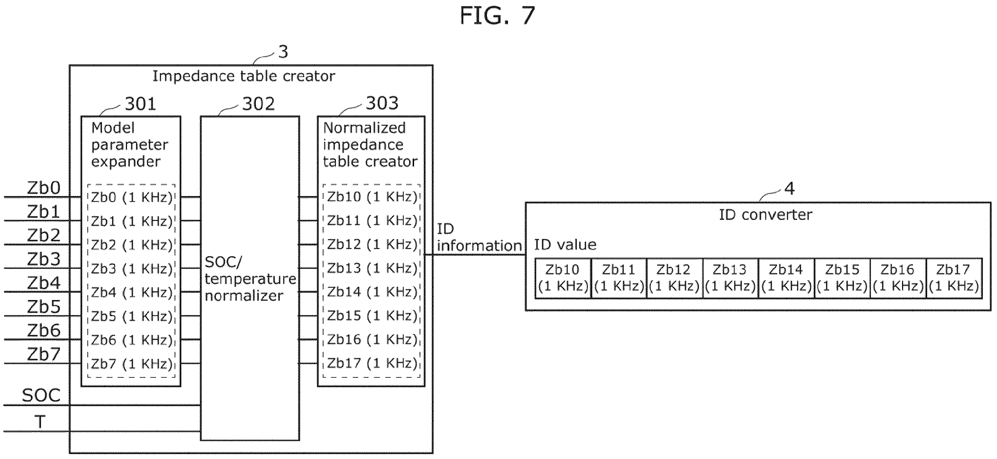

FIG. 7 illustrates an example of generating a battery ID using AC impedances at a frequency of 1 kHz in a battery pack according to Embodiment 2.

[FIG. 8]

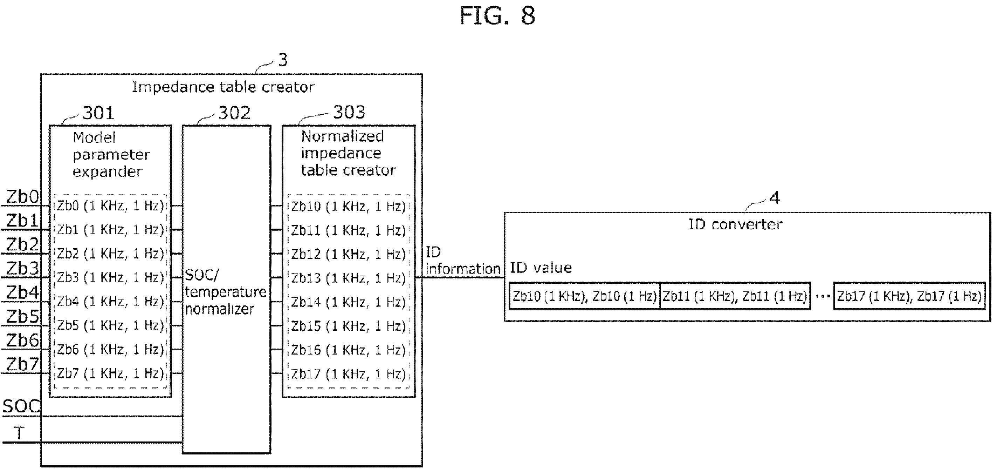

FIG. 8 illustrates an example of generating a battery ID using AC impedances at frequencies of 1 kHz and 1 Hz in a battery pack according to Embodiment 3.

[FIG. 9]

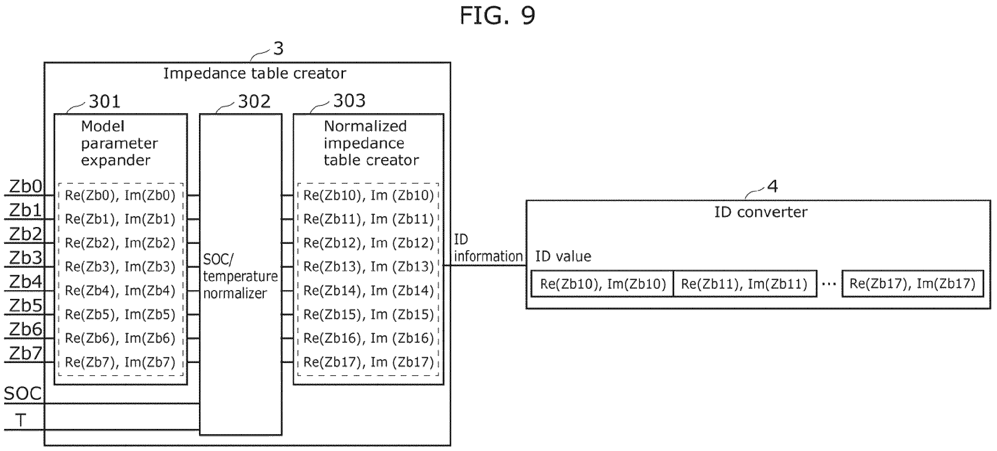

FIG. 9 illustrates an example of generating a battery ID using AC impedances in a battery pack according to Embodiment 4.

[FIG. 10]

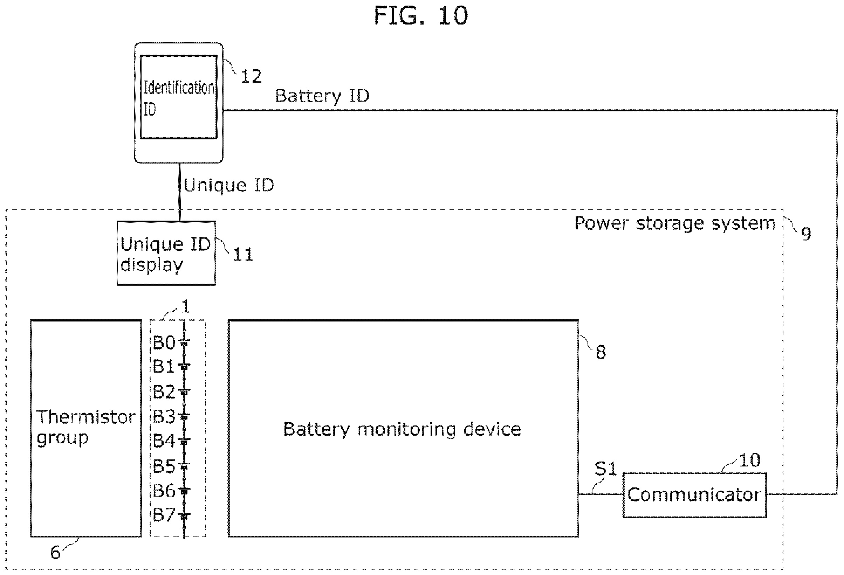

FIG. 10 illustrates an example of reading a battery ID and a unique ID according to Embodiment 5.

[FIG. 11A]

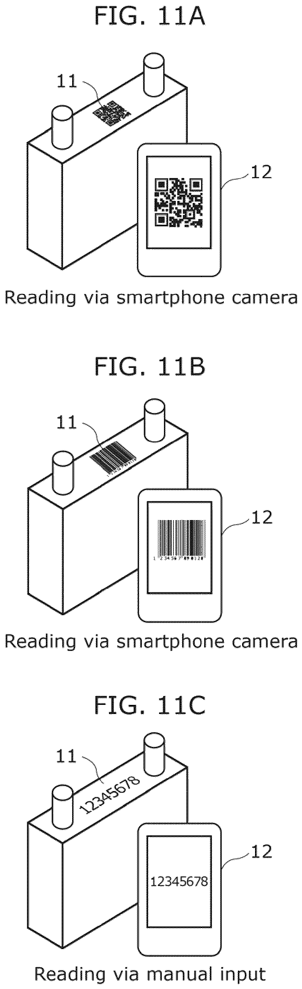

FIG. 11A illustrates a first example of a method for reading a unique ID according to Embodiment 5.

[FIG. 11B]

FIG. 11B illustrates a second example of a method for reading a unique ID according to Embodiment 5.

[FIG. 11C]

FIG. 11C illustrates a third example of a method for reading a unique ID according to Embodiment 5.

[FIG. 12]

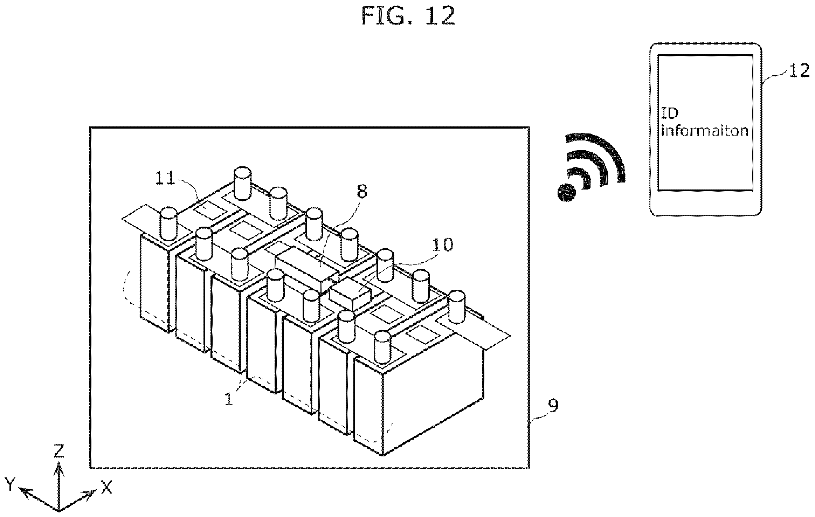

FIG. 12 illustrates one example of a method for reading a battery ID according to Embodiment 5.

[FIG. 13]

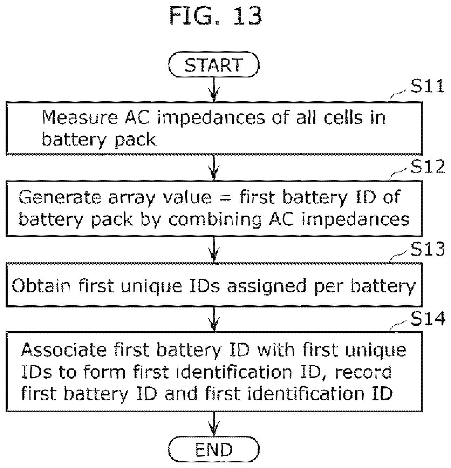

FIG. 13 is a flowchart illustrating a first example of operations for setting an ID to a battery pack.

[FIG. 14]

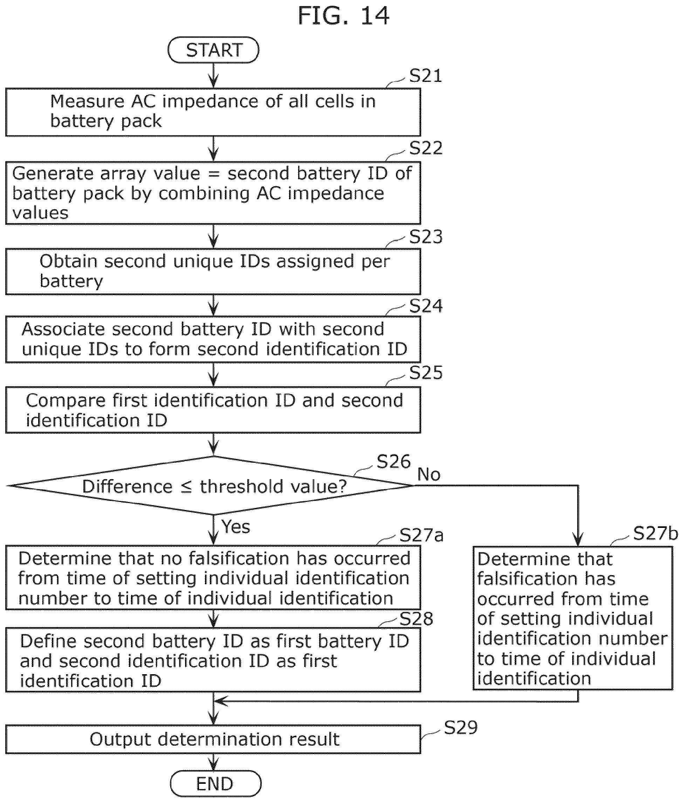

FIG. 14 is a flowchart illustrating a first example of operations for identifying individual storage batteries of a battery pack.

[FIG. 15]

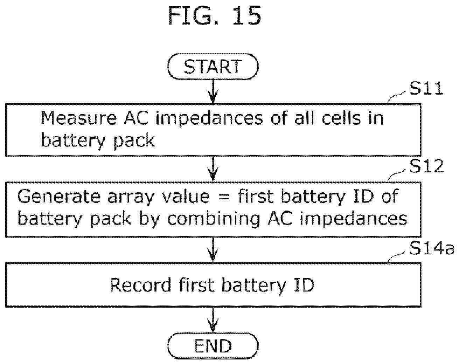

FIG. 15 is a flowchart illustrating a second example of operations for setting an ID to a battery pack.

[FIG. 16]

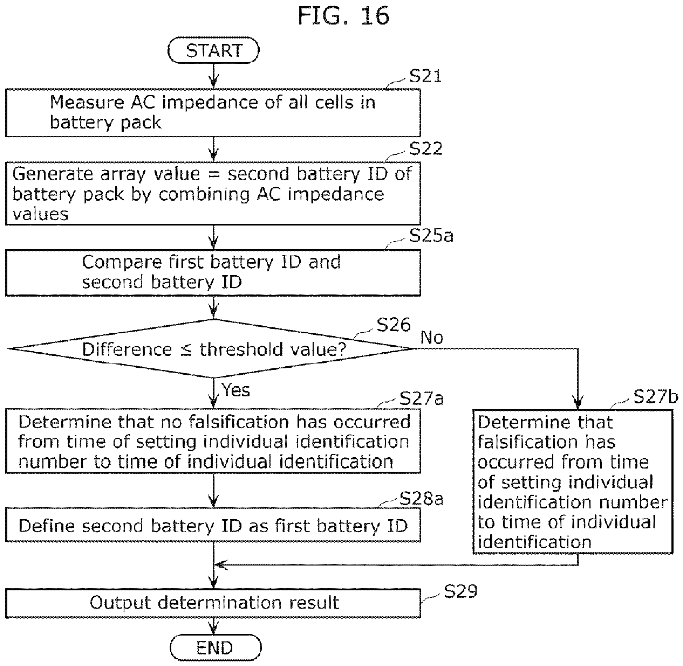

FIG. 16 is a flowchart illustrating a second example of operations for identifying individual storage batteries of a battery pack.

[FIG. 17]

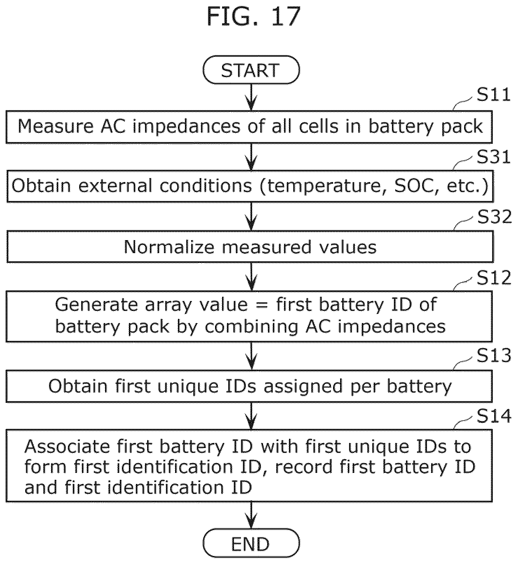

FIG. 17 is a flowchart illustrating a third example of operations for setting an ID to a battery pack.

[FIG. 18]

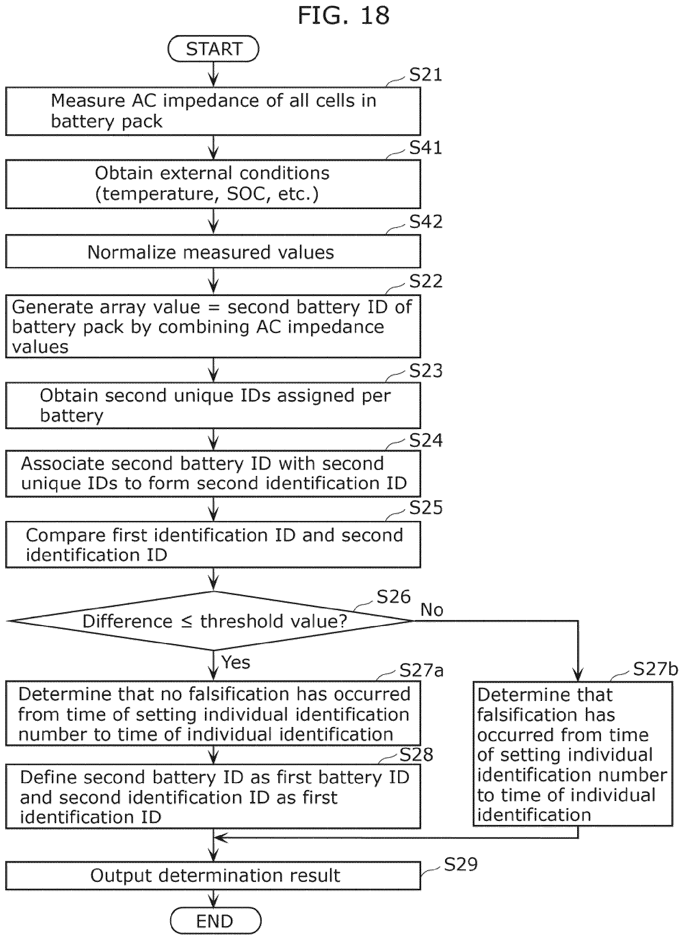

FIG. 18 is a flowchart illustrating a third example of operations for identifying individual storage batteries of a battery pack.

[FIG. 19]

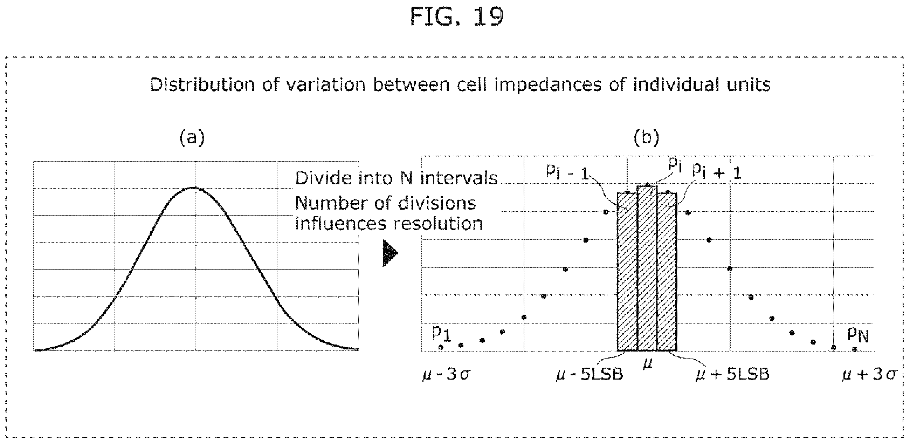

FIG. 19 illustrates a distribution of variation between cell impedances of individual units.
[FIG. 20]

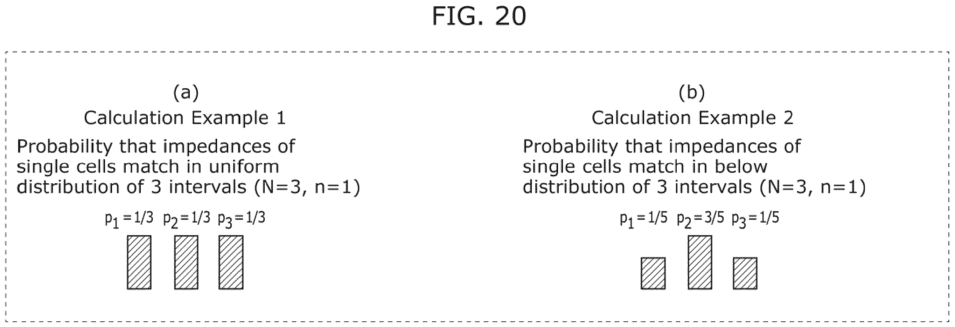

FIG. 20 is for explaining Calculation Example 1 and Calculation Example 2.
[FIG. 21A]

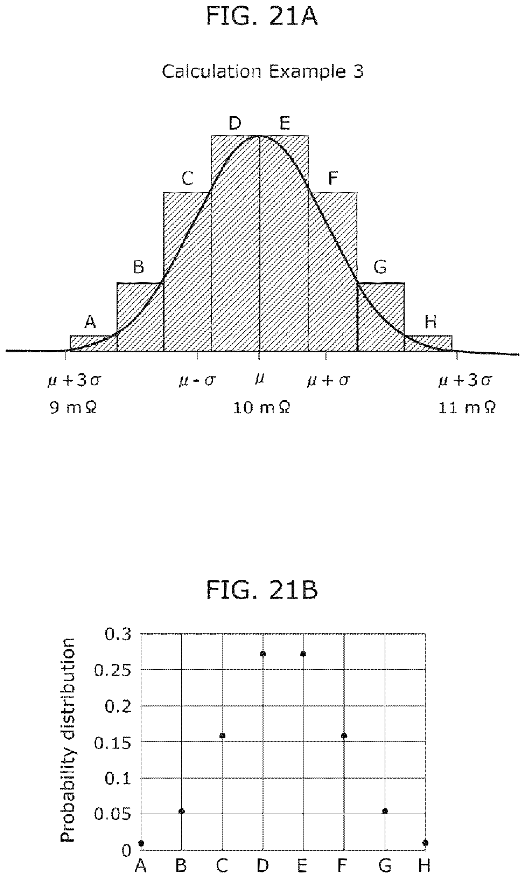

FIG. 21A illustrates the $3\sigma$ range of a normal distribution divided into 8 intervals.
[FIG. 21B]
FIG. 21B illustrates the probability distribution of A to H.
[FIG. 22A]

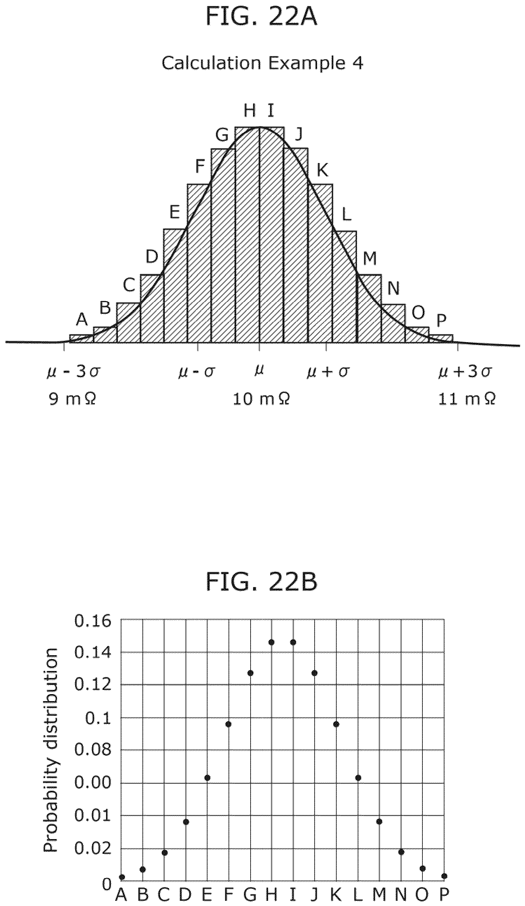

FIG. 22A illustrates the $3\sigma$ range of a normal distribution divided into 16 intervals.
[FIG. 22B]
FIG. 22B illustrates the probability distribution of A to P.

[Description of Embodiments]

(Underlying Knowledge Forming Basis of the Present Disclosure)

In recent years, applications that use secondary batteries, such as environment-friendly vehicles including electric vehicles as well as storage batteries for stably supplying renewable energy have been increasing rapidly. In many cases, lithium-ion batteries are used as such secondary batteries for their high energy density.

Efforts to build a circular battery ecosystem through secondary use such as reuse and recycling, rather than disposing of batteries after primary use, are accelerating with an eye toward reducing environmental impact and realizing a decarbonized society.

However, with the extension of the life cycle through reuse, there are concerns about the occurrence of new security risks such as falsification of battery residual value information, theft of hardware, and mixing of counterfeit products in the multiple stages until the end of life (EOL).

For example, falsification of battery residual value information includes replacement of circuit boards, falsification of IDs, and the like. Falsification of battery residual value information may include, for example, replacing a seal on which a two-dimensional code or the like indicating battery performance is printed and which is affixed to the storage battery, with a seal indicating a higher performance than the original performance, or falsifying the history stored in the memory of the circuit board inside the storage battery (for example, by replacing the circuit board). Mixing of counterfeit products refers to batteries being replaced, and includes, for example, storage batteries included in a new battery pack being replaced with degraded batteries.

Since battery residual value information is important information that determines the buying and selling price of a battery, proper measurement and protection are necessary. Therefore, normally, a battery management system (BMS) measures the voltage, current, and temperature of all of the single cells (storage batteries) included in a battery pack, and monitors the states of the batteries using this measurement data.

However, voltage alone cannot accurately assess the degradation state and the like closely related to battery residual value information. A charge-discharge method is known in which battery capacity is measured by a charge-discharge test, and the degradation state is determined according to the ratio with the initial capacity, but there are issues with this method such as it being time-consuming and requiring laboratory facilities and dedicated equipment.

One known method for ensuring traceability of batteries is to store battery information (a management number, etc.) in a two-dimensional code, and affix it to a substrate or battery during manufacturing. However, two-dimensional codes are easy to copy and thus there is a risk of falsification. In addition, affixing tags to each individual battery is labor-intensive and costly. Therefore, it is expected that in the future, determination methods that replace or supplement these current methods with additional information will be necessary.

As one method for solving these risks and issues, in recent years, proposals have been made to use the electrical characteristics of batteries as battery-specific information and manage the batteries based on that specific information. For example, PTL 1 presents a technique for sorting batteries of the same type (secondary batteries such as lithium-ion batteries and lead storage batteries) represented by an equivalent circuit (circuit model) into groups based on their characteristics. An AC impedance method for measuring voltage and current while causing a battery to sweep an AC signal is used to measure the AC impedance of a battery cell to be sorted, and the battery is sorted based on whether or not characteristic points of the measured values fall within a reference range calculated in advance based on the characteristics of a plurality of existing batteries.

However, the conventional technique does not measure all single cells in a battery pack state, but rather performs measurement in a single cell state. Moreover, the sorting uses absolute values of impedance rather than relative changes in impedance. It is therefore difficult to apply the conventional technique to a BMS. Furthermore, it is necessary to measure battery characteristics in advance with this conventional technique.

The present disclosure proposes a battery pack management system and a battery pack management method that, in storage batteries in a battery pack state, convert data acquired by AC impedance measurement into unique values of the battery pack.

A battery pack management system according to one aspect of the present disclosure manages a battery pack of storage batteries connected in series or parallel, and includes: a first acquisition unit configured to acquire respective first impedances of the storage batteries corresponding to a first time point; and a generator that generates first identification information of the battery pack based on the first impedances of the storage batteries acquired.

This generates first identification information (for example, a battery ID) using first impedances, each of which is a physical quantity unique to a storage battery that cannot be, for example, rewritten. The first impedance is resistant to falsification, and is suitable as an identifier of an individual unit. When such first identification information is used for identification of individual storage batteries, it is possible to detect whether or not an unauthorized act has been performed on the storage batteries (for example, whether a storage battery has been replaced without authorization). For example, even if a storage battery is replaced without authorization, the first identification information generated using the first impedance of the replaced storage battery will not substantially match the first identification information of the original storage battery, making it possible to detect that the storage battery has been replaced without authorization. The battery pack management system can therefore detect unauthorized acts on storage batteries and reduce the security risk to the storage batteries.

For example, the battery pack management system may further include: a calculator that calculates a first circuit parameter in each of equivalent circuit models respectively corresponding to the storage batteries, based on the first impedances. The generator may generate the first identification information of the battery pack based on the first circuit parameters of the storage batteries calculated.

This makes it possible to generate first identification information of the battery pack based on the first circuit parameters. Since it is possible to generate the first identification information by using desired parameters among the first circuit parameters or by combining parameters, diverse first identification information can be generated, and security risks to the storage batteries can be further reduced.

For example, the battery pack management system may further include: a second acquisition unit configured to acquire a state of charge of the battery pack. The calculator may include a first normalizer that normalizes the first impedances of the storage batteries with respect to the state of charge, and calculate the first circuit parameters of the storage batteries based on the first impedances of the storage batteries normalized with respect to the state of charge.

With this, the first identification information is generated according to the first impedances normalized with respect to the state of charge. Since the value of the first impedance can vary depending on the state of charge, by normalizing the first impedances with respect to the state of charge, it is possible to acquire first impedances measured at approximately the same state of charge each time. Therefore, detection accuracy improves when detecting unauthorized acts on the storage batteries using the first identification information.

For example, the battery pack management system may further include: a third acquisition unit configured to acquire a temperature of the battery pack. The calculator may include a second normalizer that normalizes the first impedances of the storage batteries with respect to the temperature, and calculate the first circuit parameters of the storage batteries based on the first impedances of the storage batteries normalized with respect to the temperature.

With this, the first identification information is generated according to the first impedances normalized with respect to temperature. Since the value of the first impedance can vary depending on the temperature, by normalizing the first impedances with respect to the temperature, it is possible to acquire first impedances measured at approximately the same temperature each time. Therefore, detection accuracy improves when detecting unauthorized acts on the storage batteries using the first identification information.

For example, the first circuit parameter may include a plurality of parameters, and the first identification information may include at least one parameter among the plurality of parameters for each of the storage batteries.

This makes it possible to generate first identification information using parameters included in the circuit parameters. The parameters are physical quantities unique to each storage battery and cannot be rewritten or the like, so they are resistant to falsification and thus suitable as identifiers of individual units.

For example, the first acquisition unit may be configured to acquire respective second impedances of the storage batteries corresponding to a second time point later than the first time point. The calculator may calculate a second circuit parameter in each of the equivalent circuit models respectively corresponding to the storage batteries, based on the second impedances of the storage batteries acquired. The generator may generate the first identification information of the battery pack corresponding to the second time point, based on the second circuit parameters of the storage batteries calculated. The battery pack management system may further include a determination unit configured to determine whether the battery pack is a same individual unit by comparing the first identification information corresponding to the first time point and the first identification information corresponding to the second time point.

This makes it possible to detect whether or not an unauthorized act (for example, a storage battery being replaced without authorization) has been performed on the storage batteries between the first time point and the second time point by comparing the first identification information corresponding to the first time point and the first identification information corresponding to the second time point. The battery pack management system can therefore detect unauthorized acts on storage batteries with the determination unit and reduce the security risk to the storage batteries.

For example, when the determination unit determines that the battery pack is the same individual unit, the generator may update identification information of the battery pack to the first identification information corresponding to the second time point.

With this, the first identification information becomes an individual identifier that includes degradation information of the storage batteries. By using such first identification information, it is possible to detect when an unauthorized act has been performed on the storage batteries, even if the storage batteries have degraded. Security risks to the storage batteries can therefore be further reduced.

For example, the generator may generate third identification information by associating the first identification information with second identification information that is assigned in advance to each of the storage batteries and is different from the first identification information.

With this, when a determination is made as to whether or not an unauthorized act has been performed on the storage batteries additionally using the second identification information (for example, the unique ID), detection accuracy is expected to further improve.

For example, the first acquisition unit may be configured to acquire respective second impedances of the storage batteries corresponding to a second time point later than the first time point. The calculator may calculate a second circuit parameter in each of the equivalent circuit models respectively corresponding to the storage batteries, based on the second impedances of the storage batteries acquired. The generator may generate one of the first identification information or the third identification information of the battery pack corresponding to the second time point, based on the second circuit parameters of the storage batteries calculated. The battery pack management system may further include a determination unit configured to determine whether the battery pack is a same individual unit by comparing the one of the first identification information or the third identification information corresponding to the first time point and the one of the first identification information or the third identification information corresponding to the second time point.

This makes it possible to detect whether or not an unauthorized act (for example, a storage battery being replaced without authorization) has been performed on the storage batteries between the first time point and the second time point by comparing the third identification information corresponding to the first time point and the third identification information corresponding to the second time point. By using the third identification information, improved detection accuracy can be expected. The battery pack management system can therefore detect unauthorized acts on storage batteries with the determination unit and further reduce the security risk to the storage batteries.

For example, when the determination unit determines that the battery pack is the same individual unit, the generator may update identification information of the battery pack to the one of the first identification information or the third identification information corresponding to the second time point.

With this, the third identification information becomes an individual identifier that includes degradation information of the storage batteries. By using such third identification information, it is possible to detect when an unauthorized act has been performed on the storage batteries, even if the storage batteries have degraded. Security risks to the storage batteries can therefore be further reduced.

For example, the second identification information may be a barcode. For example, the second identification information may be a two-dimensional code. For example, the second identification information may be a serial number.

This makes it possible to manage the second identification information using generic methods such as a barcode, a two-dimensional code, or a serial number. This increases the versatility of the battery pack management system.

For example, the battery pack management system may further include a communicator that outputs the first identification information to an external device.

This makes it possible to transmit the first identification information to an external device. For example, by providing a portion of the configuration of the battery pack management system outside the battery pack, the battery pack can be simplified.

For example, the first normalizer may calculate the state of charge based on a full charge capacity (FCC) of the battery pack and a change in charge amount of the battery pack due to charging or discharging. For example, the first normalizer may estimate the state of charge based on a relationship between state of charge and open circuit voltage.

This makes it possible to acquire the state of charge using general methods such as the coulomb counting method or estimation from the state of charge (SOC) - open circuit voltage (OCV) curve. This increases the versatility of the battery pack management system.

For example, the battery pack management system may further include: a measurement unit configured to measure the state of charge of the battery pack.

This makes it possible to acquire the state of charge by measuring it.

For example, the battery pack management system may further include: a measurement unit configured to measure the temperature of the battery pack.

This makes it possible to acquire the temperature by measuring it.

For example, the battery pack management system may further include: the battery pack; and an impedance measurement unit configured to measure respective impedances of the storage batteries.

This makes it possible to acquire the impedance of each of the storage batteries by measuring it.

For example, the generator may generate the first identification information by arranging values of the first circuit parameters of the storage batteries in an order of arrangement of the storage batteries.

With this, the order of the circuit parameter values matches the actual order of the storage batteries, so if there is a storage battery whose circuit parameters do not match, it is easy to identify that storage battery among the battery pack.

A battery pack management method according to one aspect of the present disclosure is a method of managing a battery pack of storage batteries connected in series or parallel, and includes: acquiring respective impedances of the storage batteries corresponding to a first time point; and generating identification information of the battery pack based on the impedances of the storage batteries acquired.

This provides the same advantageous effects as the above-described battery pack management system.

Note that these general or specific aspects may be achieved by a system, a method, an integrated circuit, a computer program, a computer-readable recording medium such as a CD-ROM, or any combination thereof.

Hereinafter, embodiments of the present disclosure will be described in detail with reference to the drawings. The embodiments described below each illustrate one specific example of the present disclosure. The numerical values, shapes, materials, elements, the arrangement and connection of the elements, steps, order of the steps, etc., shown in the following embodiments are mere examples, and therefore do not limit the scope of the present disclosure. Accordingly, among the elements in the following embodiments, those not recited in any of the independent claims are described as optional elements.

The figures are schematic diagrams and are not necessarily precise illustrations. Elements that are essentially the same share the same reference signs in the figures, and duplicate description is omitted or simplified.

In the present specification, terms indicating relationships between elements such as "same", numerical values, and numerical ranges refer not only to their strict meanings, but encompass a range of essentially equivalents, such as a range of deviations of approximately a small percent (for example 10%).

In the present specification, ordinal numbers such as "first" and "second" are used not to imply a specific number or order of elements, unless specifically stated otherwise, but rather to avoid confusion among similar components and to distinguish them.

[Embodiment 1]

First, the configuration of the power storage system according to the present embodiment will be described. FIG. 1 is a block diagram illustrating the functional configuration of power storage system 9 according to the present embodiment. Battery pack 1 includes storage batteries B0 through B7 (hereinafter, any one of storage batteries B0 through B7 is also referred to as storage battery B), and is configured by connecting storage batteries B0 through B7 in series or parallel. Stated differently, storage battery B is a single cell (battery cell). Storage battery B is specifically a lithium-ion battery, but may be any other battery such as a nickel metal hydride battery. Battery pack 1 functions as a power supply and supplies power to a load. The load is, for example, a motor of an electric vehicle (EV), but is not particularly limited. A battery charger for charging battery pack 1, instead of a load, may be connected.

Power storage system 9 includes battery pack 1, battery monitoring device 8, thermistor group 6, communication line S1, communicator 10, and unique ID display 11. The battery pack management system (battery management system) according to the present disclosure is an information processing system for managing battery pack 1 by, for example, generating identification information for battery pack 1, and includes a part or all of power storage system 9. The battery pack management system may further include a configuration for identifying an individual battery pack 1.

Battery monitoring device 8 includes impedance measurement unit 2, impedance table creator 3, ID converter 4, SOC measurement unit 5, temperature measurement unit 7, and communication line S1. Battery monitoring device 8 is included in, for example, a battery management system (BMS). Battery monitoring device 8 includes, for example, one or more integrated circuits. The functions of impedance table creator 3 and the functions of ID converter 4 may be implemented by a processor executing a program, by a dedicated circuit, or by a combination thereof.

Impedance measurement unit 2 measures alternating current (AC) impedances $Zb0$ through $Zb7$ of battery pack 1. More specifically, impedance measurement unit 2 applies a control signal including a plurality of frequency components to a control terminal of a transistor, and measures current $I$ flowing through a reference resistor and voltage $Vn$ of storage battery $Bn$. Impedance measurement unit 2 converts the measured current $I$ to a complex current and converts the measured voltage $Vn$ to a complex voltage. Thereafter, impedance measurement unit 2 performs an averaging process of averaging the complex currents and an averaging process of averaging the complex voltages. AC impedance $Zbn$ of storage battery $Bn$ is calculated by dividing the complex voltage resulting from the complex voltage averaging process by the complex current resulting from the complex current averaging process. Here, in the example of FIG. 1, $n$ ranges from 0 to 7. Each of the AC impedances is a complex number, and includes real component $Re(Zb)$ and imaginary component Im(Zb). For example, real component (real part) Re(Zb0) and imaginary component (imaginary part) Im(Zb0) of the impedance are output as the AC impedance of storage battery B0. Note that hereinafter, AC impedances Zb0 through Zb7 may also simply be referred to as "impedances" in some cases.

Impedance table creator 3 generates model parameters (also referred to as circuit parameters) from AC impedances Zb0 through Zb7, and tabulates them. Impedance table creator 3 includes model parameter expander 301, SOC/temperature normalizer 302, and normalized impedance table creator 303. Impedance table creator 3 is one example of a calculator.

Model parameter expander 301 acquires AC impedances Zb0 through Zb7 from impedance measurement unit 2, and expands each of the acquired AC impedances Zb0 through Zb7 into model parameters. Model parameter expander 301 also functions as a first acquisition unit.

SOC/temperature normalizer 302 normalizes each of the expanded parameters with respect to at least one of an SOC parameter or a temperature parameter. SOC/temperature normalizer 302 acquires the SOCs of each of storage batteries B0 through B7 from SOC measurement unit 5 when impedance measurement unit 2 measures the impedances. The SOC may be the SOC immediately before or immediately after measuring the impedance, or may be an average value, median value, mode, or the like of SOCs at a plurality of time points. SOC/temperature normalizer 302 acquires temperatures T of each of storage batteries B0 through B7 from temperature measurement unit 7 when impedance measurement unit 2 measures the impedances. Temperature T may be temperature T at any point in time during the period of measuring the impedance, or may be an average value, median value, mode, or the like of temperatures T at a plurality of time points. SOC/temperature normalizer 302 functions as a second acquisition unit that acquires the SOC and a third acquisition unit that acquires the temperature.

Note that SOC/temperature normalizer 302 is communicably connected to each of SOC measurement unit 5 and temperature measurement unit 7. SOC/temperature normalizer 302 is one example of a normalizer.

SOC measurement unit 5 measures the SOC of battery pack 1. SOC measurement unit 5 acquires a current and a voltage of battery pack 1, or of each single cell included in battery pack 1, and calculates the SOC by a coulomb counting method or by estimation from an SOC-OCV (Open Circuit Voltage) curve. The coulomb counting method and SOC-OCV curve will be described later with reference to FIG. 5A and FIG. 5B.

The impedance of storage battery B changes due to SOC, temperature, and degradation, but the degradation does not occur suddenly. Therefore, if SOC/temperature normalizer 302 can normalize the SOC and temperature to standard values (for example, a SOC of 50% and a temperature of 25°C), the impedance can be used as a battery ID regardless of environmental changes (SOC, temperature).

Temperature measurement unit 7 measures the temperature of battery pack 1. Temperature measurement unit 7 is connected to thermistor group 6 disposed in proximity to battery pack 1, and measures temperature T of thermistor group 6. Thermistor group 6 is a temperature sensor that uses a thermistor, but may be a temperature sensor that uses any other element such as a thermocouple.

Normalized impedance table creator 303 tabulates the parameters normalized by SOC/temperature normalizer 302.

ID converter 4 generates a battery ID (a single battery ID) of battery pack 1 based on model parameters of each of storage batteries B0 through B7. In the present embodiment, ID converter 4 generates a battery ID based on AC impedances Zb0 through Zb7 that are normalized according to at least one of SOC or temperature. ID converter 4, for example, generates a battery ID of battery pack 1 by combining at least one or more of the parameters tabulated by impedance table creator 3. ID converter 4 extracts parameters for generating a battery ID from the tabulated parameters for each of storage batteries B, and generates a battery ID of battery pack 1 by combining the extracted parameters.

ID converter 4 transmits ID information indicating the battery ID to communicator 10 via communication line S1. The battery ID is one example of first identification information.

Thus, power storage system 9 is configured to, for example, perform AC impedance measurement on all of the single cells of storage battery B in a battery pack state, generate model parameters after normalizing the measured AC impedances Zb0 through Zb7 with respect to SOC and temperature, and generate a battery ID (a first unique value) based on those model parameters.

Communication line S1 is used for communication between ID converter 4 and communicator 10.

Communicator 10 notifies a higher-level system (for example, an external device) of the ID information indicating the battery ID received from ID converter 4. Communicator 10 includes, for example, a wireless communication module (a wireless communication circuit) for wireless communication, or a wired communication module (a wired communication circuit) for wired communication.

Unique ID display 11 is affixed to storage battery B (battery cell), battery pack 1, or power storage system 9, and displays a unique ID assigned to each storage battery B, each battery pack 1, or each power storage system 9 at the time of battery manufacture using one or more methods from among a barcode, a two-dimensional code, and a serial number. Stated differently, in power storage system 9, the unique IDs are managed using one or more methods from among a barcode, a two-dimensional code, and a serial number. For example, the unique ID is one of a barcode, a two-dimensional code, or a serial number. The unique ID is one example of second identification information.

Next, the flow of operations performed by power storage system 9 will be described.

Impedance measurement unit 2 measures AC impedances Zb0 through Zb7 of each storage battery in battery pack 1 while sweeping the frequency. Model parameter expander 301 expands frequency characteristic values of AC impedances Zb0 through Zb7 into model parameters. For example, SOC/temperature normalizer 302 may normalize the frequency characteristic values of AC impedances Zb0 through Zb7 to standard values (for example, a temperature of 25°C and an SOC of 50%) with respect to the ambient temperature and the SOC. Normalized impedance table creator 303 generates a normalized impedance table, which is a table of normalized impedances, from the model parameters, and ID converter 4 generates a battery ID from that table. The ID information indicating the generated battery ID is transmitted to an external system via communicator 10.

The SOC is measured by SOC measurement unit 5 from a current value of battery pack 1 and voltage values of the single cells included in battery pack 1. The ambient temperature is measured by temperature measurement unit 7 connected to thermistor group 6 disposed in proximity to battery pack 1. Battery monitoring device 8 includes unique ID display 11 that displays information related to the unique ID assigned in advance to storage battery B (battery cell), battery pack 1, or power storage system 9 for individual identification.

Hereinafter, a first implementation example of the present disclosure will be given. FIG. 2 is a block diagram illustrating the functional configuration of impedance table creator 3 according to the present embodiment. In FIG. 2, indication of reactance components of the parameters of the equivalent circuit is omitted.

Model parameter expander 301 expands the frequency characteristic values of AC impedances Zb0 through Zb7 of all the single cells included in battery pack 1 into, for example, the equivalent circuit illustrated in FIG. 4B and to be described later (for example, inductor L, resistor (resistive element) R0, resistor R1, capacitive element C1, resistor R2, and capacitive element C2). Here, to expand means to calculate the model parameters (circuit parameters) L, R0, R1, C1, R2, and C2 of the equivalent circuit from AC impedances Zb0 through Zb7.

Model parameter expander 301 calculates, for example, model parameters R0(0), R1(0), C1(0), R2(0), and C2(0) of the equivalent circuit of storage battery B0 based on AC impedance Zb0, and calculates model parameters R0(1), R1(1), C1(1), R2(1), and C2(1) of the equivalent circuit of storage battery B1 based on AC impedance Zb1. AC impedances Zb2 and subsequent AC impedances are calculated in a similar manner. L, R0, R1, C1, R2, and C2 are one example of a plurality of parameters among the model parameters (circuit parameters).

The numerical values (parameters of the equivalent circuit before being normalized) enclosed by the dashed line frame in model parameter expander 301 illustrated in FIG. 2 are an unnormalized impedance table.

SOC/temperature normalizer 302 normalizes the acquired complex model (equivalent circuit model) of the equivalent circuit to a standard temperature and standard SOC.

Normalized impedance table creator 303 expands from the normalized model to the model parameters, and generates a normalized impedance table. The numerical values (parameters of the normalized equivalent circuit) enclosed by the dashed line frame in normalized impedance table creator 303 illustrated in FIG. 2 are a normalized impedance table. The normalized impedance table is a collection of numerical values that are candidates for generating the battery ID, and indicate the electrical characteristics of battery pack 1 at the time of measurement of the impedance.

ID converter 4 then generates a battery ID of battery pack 1 from that table. For example, if battery pack 1 is configured of eight storage batteries connected in series, ID converter 4 generates a value sequence in which the R0 values of the eight storage batteries are arranged in order as the battery ID. It is of course also possible to generate a more complex ID by combining two or more parameters.

Here, examples of the generated battery ID will be described with reference to FIG. 3A and FIG. 3B. FIG. 3A illustrates an example of an ID value generated by ID converter 4 according to the present embodiment. FIG. 3B illustrates another example of an ID value generated by ID converter 4 according to the present embodiment.

FIG. 3A illustrates an example in which a battery ID (ID value in FIG. 3A) is generated with a value sequence in which R10 values (normalized values of R0) of the eight storage batteries B0 through B7 are arranged in order. Note that the battery ID is not limited to being generated using resistor R0 values, and may be generated as a value sequence in which at least one circuit parameter among circuit parameters L, R0, R1, C1, R2, and C2 is arranged in order.

FIG. 3B illustrates an example in which a battery ID (ID value in FIG. 3B) is generated with a value sequence in which R10 values and R11 values of the eight storage batteries B0 through B7 are arranged in order. Note that the battery ID is not limited to being generated using two circuit parameters, and may be generated as a value sequence in which any two or more circuit parameters among circuit parameters L, R0, R1, C1, R2, and C2 are arranged in order.

Thus, the battery ID is configured to include at least one parameter among the plurality of circuit parameters for each of storage batteries B0 through B7.

Performing this ID conversion process makes it possible to convert AC impedances Zb0 through Zb7 of the single cells included in battery pack 1 into the battery ID of battery pack 1.

The following is one example of a method in which model parameter expander 301 expands measured AC impedances Zb0 through Zb7 into model parameters (L, R0, R1, C1, R2, and C2) of the equivalent circuit.

FIG. 4A illustrates an example of the AC impedance measurement results of storage battery B according to the present embodiment. FIG. 4A illustrates a Nyquist diagram acquired by measuring the AC impedance of storage battery B. The graph illustrated in FIG. 4A is a diagram referred to as a Cole-Cole plot, and is also referred to as a Nyquist plot. The horizontal axis in FIG. 4A represents the real component $Re(Zb)$, and the vertical axis represents imaginary component $Im(Zb)$. FIG. 4A illustrates the results of measuring the impedance by sweeping the frequency from 0.1 Hz to 1000 Hz.

Model parameter expander 301 acquires the AC impedance measurement results illustrated in FIG. 4A from impedance measurement unit 2 for each of storage batteries B0 through B7.

FIG. 4B illustrates one example of a battery model that is the equivalent circuit of storage battery B according to the present embodiment. In FIG. 4B, $U_L$ indicates the open-circuit voltage. The battery model is an equivalent circuit model of storage battery B.

As illustrated in FIG. 4B, it is conceivable that storage battery B has a circuit configuration in which the following are connected in series to each other: inductor L; resistor R0; resistor (resistive element) R1 and capacitive element C1 connected in parallel; and resistor R2 and capacitive element C2 connected in parallel. In the example here, a battery model is presented as including one inductor, three resistors, and two capacitors, but the number of inductors, resistors, and capacitors are not limited to this example. For example, a battery model may be presented as including four or more resistors and three or more capacitors. The number of resistors may be the same as or different from the number of capacitors. The battery model illustrated in FIG. 4B is preset at the time of factory shipment of battery pack 1. The battery model is, for example, set individually for each of storage batteries B0 through B7 included in battery pack 1, but a single battery model may be set in common for storage batteries B0 through B7.

The characteristics of area I illustrated in FIG. 4A mainly depend on inductor L (for example, the terminals and wiring of storage battery B) illustrated in FIG. 4B, the characteristics of area II mainly depend on resistor R0 (the electrolyte of storage battery B), the characteristics of area III depend on resistor R1 and capacitive element C1 (the negative electrode of storage battery B), and the characteristics of area IV mainly depend on resistor R2 and capacitive element C2 (the positive electrode and diffusion of storage battery B).

FIG. 4C is a relational expression of AC impedances Zb0 through Zb7 and model parameters according to the present embodiment. The relational expression in FIG. 4C illustrates the relationship between the AC impedance illustrated in FIG. 4A and the model parameters illustrated in FIG. 4B. The variable "n" in FIG. 4C is 2 in the case of the equivalent circuit model illustrated in FIG. 4B.

Impedance table creator 3 generates the graph illustrated in FIG. 4A for each of AC impedances Zb0 through Zb7, and calculates the model parameters of the equivalent circuit illustrated in FIG. 4B that satisfy the generated graph using the relational expression in FIG. 4C.

As described above, it is possible to expand the frequency characteristic values of AC impedances Zb0 through Zb7 of storage battery B into model parameters of an equivalent circuit.

Below an example will be given in which SOC/temperature normalizer 302 normalizes the parameters acquired by model parameter expander 301 to standard values (for example, a temperature of 25°C and an SOC of 50%) with respect to the ambient temperature measured by temperature measurement unit 7 and the SOC measured by SOC measurement unit 5.

FIG. 5A is for explaining the coulomb counting method, which is one example of a method for calculating the state of charge.

As illustrated in FIG. 5A, in the coulomb counting method, the charging/discharging current of the battery from a known OCV (SOC) is integrated to acquire the changed charge amount (coulombs), and the SOC is calculated from the full charge capacity (FCC; battery capacitance at full charge) that is known in advance. For example, using the coulomb counting method, SOC/temperature normalizer 302 calculates the SOC based on the FCC of battery pack 1 and the change in charge amount of battery pack 1 due to charging/discharging.

FIG. 5B is for explaining the estimation method from the SOC-OCV curve, which is another example of a method for calculating the state of charge.

As illustrated in FIG. 5B, in the estimation from the SOC-OCV curve, the SOC-OCV curve of the same type of battery is measured in advance, and the SOC is calculated by measuring the OCV of an arbitrary battery of the same type. For example, SOC/temperature normalizer 302 estimates the SOC based on the relationship between the SOC and the open circuit voltage (for example, the SOC-OCV curve).

The SOC described above indicates the ratio of the remaining battery capacity (Ah) to the battery capacity (Ah) when fully charged, and the OCV refers to the battery voltage in a state where current has not flowed through the battery for a certain period of time or longer and the polarization inside the battery has converged (resting state). The time required for the polarization to converge varies depending on the battery type, but generally, it takes approximately 30 minutes or more.

FIG. 6A is for explaining an example of normalization of a Nyquist plot of impedance of storage battery B with temperature as a parameter. This Nyquist plot of the storage battery impedance exhibits a change that follows the Arrhenius equation with respect to temperature. Therefore, the temperature variation characteristic of the Nyquist plot of the storage battery impedance (refer to (a) in FIG. 6A) is acquired in advance for the same type of storage battery, and the Arrhenius coefficient is determined. Based on the determined Arrhenius coefficient, after measuring the Nyquist plot of the same type of storage battery to be measured at an arbitrary temperature, the Nyquist plot is converted to a Nyquist plot at a standard temperature in accordance with the Arrhenius equation (refer to (b) in FIG. 6A). This allows a Nyquist plot converted to a standard temperature to always be acquired even if the ambient temperature at the time of measurement differs from the standard temperature.

FIG. 6B is a diagram illustrating the results of performing normalization of a Nyquist plot of impedance of storage battery B with temperature as a parameter on actual measurement data.

In FIG. 6B, (a) illustrates, as temperature-dependent actual measurement data, the result of superimposing graphs by converting Nyquist plots actually measured at 0°C, 25°C, and 45°C to 25°C by normalization, and the three plots are almost overlapping. In FIG. 6B, (b) illustrates, as temperature-dependent actual measurement data, the temperature dependence of the Nyquist plot without performing normalization. As illustrated in FIG. 6B, since the storage battery impedance has a temperature variation characteristic, it is desirable to perform normalization as illustrated in FIG. 6A.

[Embodiment 2]

In the present embodiment, a method of using a fixed frequency as a model parameter of the impedance of storage battery B is described. FIG. 7 illustrates an example of generating a battery ID using AC impedances Zb0 through Zb7 at a frequency of 1 kHz in battery pack 1 according to the present embodiment. In such cases, ID converter 4 generates, as the battery ID, a value sequence in which the AC impedances (for example, normalized AC impedances) at a frequency of 1 kHz are arranged.

The method of generating the battery ID is the same as the implementation example illustrated in FIG. 2, but in the present embodiment, the battery ID can be generated easily without sweeping the frequency. Note that the frequency is not limited to 1 kHz, and may be any fixed frequency.

[Embodiment 3]

In the present embodiment, a method of using a fixed frequency as a model parameter of the impedance of storage battery B is described. FIG. 8 illustrates an example of generating a battery ID using AC impedances Zb0 through Zb7 at frequencies of 1 kHz and 1 Hz in battery pack 1 according to the present embodiment. In such cases, ID converter 4 generates, as the battery ID, a value sequence in which the AC impedances (for example, normalized AC impedances) at frequencies of 1 kHz and 1 Hz are arranged.

According to the present embodiment, it is possible to generate a more complex battery ID by combining AC impedances at two or more fixed frequencies. Note that the frequencies are not limited to 1 kHz and 1 Hz, and may be any two or more fixed frequencies.

[Embodiment 4]

In the present embodiment, a method of using the real and imaginary components of the impedance as model parameters of the impedance of storage battery B is described. FIG. 9 illustrates an example of generating a battery ID using AC impedances (complex impedances) in battery pack 1 according to the present embodiment. In the example illustrated in FIG. 9, complex impedances are measured, and the measured complex impedances are used to generate a battery ID. In such cases, ID converter 4 generates, as the battery ID, a value sequence in which the real components Re(Zb) and imaginary components Im(Zb) of the complex impedances are arranged.

According to the present embodiment, by treating the real and imaginary components as separate parameters, the number of parameters that can be handled in the normalized impedance table can be increased, enabling generation of a more complex battery ID.

[Embodiment 5]

In the present embodiment, one example of a method for identifying and managing storage battery B using the generated battery ID will be shown.

FIG. 10 illustrates an example of reading a battery ID and a unique ID according to the present embodiment. FIG. 10 illustrates a configuration of a system for reading a battery ID and a unique ID.

Power storage system 9 includes a unique ID assigned in advance to storage battery B (battery cell), battery pack 1, or power storage system 9, and a battery ID derived from storage battery impedance (AC impedance) determined by battery monitoring device 8. Unique ID display 11 displays information based on the unique ID using a barcode, a two-dimensional code, a serial number, or the like. ID reading device 12, which is an external device, identifies the individual power storage system 9 by numerical input or by optically reading unique ID display 11. It is also possible to identify the battery ID derived from the storage battery impedance determined by battery monitoring device 8 by reading it with ID reading device 12, which is an external device, via communicator 10.

Note that the unique ID is an ID different from the battery ID and is set for each storage battery B at the time of factory shipment, for example. The unique ID is also an ID that is fixed and does not change over time. The unique ID is also an ID that does not depend on the impedance of storage battery B.

ID reading device 12 may further generate a third unique value for identification by associating the battery ID with the unique ID (hereinafter "identification ID"), and may identify an individual unit using the identification ID. The third unique value includes an ID that is invariant (unique ID) and an ID that can change over time according to the impedance of storage battery B (battery ID). It is possible to use either the battery ID or the unique ID alone, but using the two together makes it possible to improve the individual unit identification rate. Using the identification ID makes recovery possible when either the battery ID or the unique ID is misrecognized. Note that the third unique value is one example of third identification information. ID reading device 12 may be included in the battery pack management system (battery management system). Moreover, ID reading device 12 may also function as a generator and a determination unit.

Here, an implementation example of a method for reading the unique ID will be described. The unique ID is displayed on unique ID display 11 affixed to the battery pack or the like, and is read by ID reading device 12, which is an external device. FIG. 11A illustrates a first example of a method for reading a unique ID according to the present embodiment. FIG. 11B illustrates a second example of a method for reading a unique ID according to the present embodiment. FIG. 11C illustrates a third example of a method for reading a unique ID according to the present embodiment.

FIG. 11A illustrates a case where a unique ID is read by an optical method using a two-dimensional code (QR code (registered trademark)), and FIG. 11B illustrates a case where a unique ID is read by an optical method using a barcode. In FIG. 11A and FIG. 11B, the unique ID is read by a camera included in ID reading device 12 (for example, a smartphone). FIG. 11C illustrates a case where a character/numeric string such as a serial number displayed on power storage system 9 is manually input to ID reading device 12, which is an external device, using a keyboard or the like. Note that the reading method used by ID reading device 12, which is an external device, may be some other method, and is not limited.

Next, an implementation example of a method for reading the battery ID will be described. FIG. 12 illustrates one example of a method for reading a battery ID according to the present embodiment. The X-axis, the Y-axis, and the Z-axis are illustrated in FIG. 12. The X-axis, the Y-axis, and the Z-axis represent the three axes of a right-handed three-dimensional orthogonal coordinate system. The Y-axis direction is the direction in which storage batteries B are arranged.

As illustrated in FIG. 12, the battery ID generated by battery monitoring device 8 is transferred to ID reading device 12, which is an external device, via communicator 10. The wireless communication between communicator 10 and ID reading device 12 is short-range wireless communication such as NFC (registered trademark, same applies below) or Bluetooth (registered trademark), or communication via a wireless Local Area Network (LAN) such as Wi-Fi (registered trademark), but is not limited thereto. When communicator 10 uses NFC and the battery ID generated by battery monitoring device 8 is pre-recorded in the NFC memory of communicator 10, there is an advantage that the battery ID can be read out even when battery monitoring device 8 cannot be activated due to low voltage of storage battery B. The communication between communicator 10 and ID reading device 12 may be wired communication (communication over a wired connection), and may use any method supported by ID reading device 12, such as a method using Universal Serial Bus (USB) (registered trademark), Controller Area Network (CAN) (registered trademark), Universal Asynchronous Receiver/Transmitter (UART) (registered trademark), etc., but is not limited thereto.

In the implementation example, a smartphone is shown as one example of ID reading device 12, which is an external device, but ID reading device 12 may be any device as long as it is capable of communicating with communicator 10. ID reading device 12 may be a portable terminal such as a tablet, may be a stationary terminal device (for example, a PC) such as a personal computer or server, or may be another device. When ID reading device 12 is a smartphone or tablet, a user can easily read out the ID using the external device.

A server is a server device located in a place separate from power storage system 9, and may be what is commonly referred to as a cloud server. The server device is communicably connected to, for example, another server device via a cloud network. A relay device, which is not illustrated in FIG. 1, may be interposed between communicator 10 and the server device. For example, the server device manages the battery ID, the unique ID, and the identification ID of battery pack 1. Storing the ID information in the server device improves security, and it is expected that the risk of the ID being falsified as reuse information will be further reduced.

Next, a first example of operations in the battery pack management system will be described with reference to FIG. 13 and FIG. 14. FIG. 13 is a flowchart illustrating a first example of operations (battery pack management method) for setting an ID (here, a battery ID and an identification ID) to battery pack 1. The operations illustrated in FIG. 13 are executed before shipping power storage system 9 as a product (one example of a first time point).

As illustrated in FIG. 13, first, impedance measurement unit 2 measures the AC impedance (one example of a first impedance) of all cells in battery pack 1 (S11). Impedance measurement unit 2 measures AC impedances Zb0 through Zb7 of all the single cells (storage batteries B) included in battery pack 1. Impedance measurement unit 2 outputs measured AC impedances Zb0 through Zb7 to model parameter expander 301.

Next, impedance table creator 3 and ID converter 4 generate an array value = a first battery ID of battery pack 1 based on (for example, by combining) each of AC impedances Zb0 through Zb7 (S12). Using the methods shown in the above Embodiments 1 through 4, a first battery ID of battery pack 1 is generated from the measured AC impedances Zb0 through Zb7. The generated first battery ID is transmitted to ID reading device 12 via communicator 10. Note that the battery ID generated in step S12 is also referred to as the battery ID at the first time point or the initial value of the battery ID.

Next, ID reading device 12, which is an external device, acquires first unique IDs assigned per storage battery B (S13). ID reading device 12 acquires the first unique IDs by reading each two-dimensional code or the like of unique ID display 11 affixed per storage battery B.

ID reading device 12 then associates the first battery ID with the first unique IDs to form a first identification ID, and records the first battery ID and the first identification ID (S14). ID reading device 12 generates the first identification ID by associating these two IDs, and records the generated first identification ID and the first battery ID in any location (memory) inside or outside power storage system 9. However, these IDs can be updated as appropriate, and for example, the operation manager of power storage system 9 can reset them as necessary when starting operation of a plurality of power storage systems 9.

Operations for identifying individual storage batteries B0 through B7 will be further described with reference to FIG. 14. FIG. 14 is a flowchart illustrating a first example of operations (battery pack management method) for identifying individual storage batteries B0 through B7 of battery pack 1. The operations illustrated in FIG. 14 are executed after power storage system 9 is shipped and starts operation (one example of a second time point). The operations illustrated in FIG. 14 may be executed when it is desired to identify individual storage batteries B0 through B7 in battery pack 1 after the start of operation, or may be executed periodically.

As illustrated in FIG. 14, first, impedance measurement unit 2 measures the AC impedance (one example of a second impedance) of all cells in battery pack 1 (S21). Impedance measurement unit 2 measures AC impedances Zb0 through Zb7 of all the single cells (storage batteries B) included in battery pack 1. Impedance measurement unit 2 outputs measured AC impedances Zb0 through Zb7 to model parameter expander 301.

Next, impedance table creator 3 and ID converter 4 create an array value = a second battery ID of battery pack 1 based on (for example, by combining) each of AC impedances Zb0 through Zb7 (S22). Using the methods shown in the above Embodiments 1 through 4, a second battery ID of battery pack 1 is generated from the measured AC impedances. When generating a battery ID using an equivalent circuit model, the equivalent circuit model used here is the same as the equivalent circuit model used in step S12. The parameters (for example, R10 illustrated in FIG. 3A) extracted to generate the second battery ID in step S22 are the same as the parameters extracted to generate the first battery ID in step S12. The second battery ID generated in step S22 is one example of first identification information at the second time point. The generated second battery ID is transmitted to ID reading device 12 via communicator 10.

Next, ID reading device 12 associates the second battery ID at the second time point with the second unique IDs to generate a second identification ID (S24). ID reading device 12 may record the generated second identification ID.

Next, ID reading device 12 compares the second identification ID generated in step S24 with the first identification ID generated in step S14 illustrated in FIG. 13 (S25). ID reading device 12 determines whether the second identification ID matches the first identification ID, or whether a difference is less than or equal to a threshold value. ID reading device 12 determines, for each storage battery B, whether the parameter of storage battery B in the second identification ID matches the parameter of storage battery B in the first identification ID, or whether a difference is less than or equal to a threshold value. The threshold value is preset and stored in ID reading device 12. Note that, since the parameters to be compared have measurement errors, ID reading device 12 may determine that a difference is less than or equal to a threshold value (for example, the IDs are the same) if there is a mismatch within ±20%, for example. The comparison (determination) in step S25 is executed for each and every storage battery B in battery pack 1.

Next, if the difference between the two identification IDs is less than or equal to the threshold value (Yes in S26), ID reading device 12 determines that no falsification has occurred to battery pack 1 from the time of setting the individual identification number (time of execution of the operations illustrated in FIG. 13) to the time of individual identification (time of execution of the operations illustrated in FIG. 14) (S27a). For example, ID reading device 12 determines that battery pack 1 is the same individual unit at the time of setting the individual identification number and at the time of individual identification.

Next, ID reading device 12 defines the second battery ID and the second identification ID as the first battery ID and the first identification ID, respectively (S28). ID reading device 12 redefines the second battery ID and the second identification ID as the first battery ID and the first identification ID. ID reading device 12 updates the values of the first battery ID and the first identification ID to the values of the second battery ID and the second identification ID (updates to the latest IDs). In step S28, for example, the identification information of all storage batteries B for which Yes was determined in step S26 is updated.

In this way, in step S28, the first battery ID and the first identification ID are updated based on AC impedances Zb0 through Zb7 at the second time point.

However, if the difference between the two battery IDs exceeds the threshold value (No in S26), ID reading device 12 determines that falsification has occurred from the time of setting the individual identification number to the time of individual identification (S27b).

Next, ID reading device 12 outputs these determination results (S29). ID reading device 12 may notify the determination results to a higher-level system, or may display the determination results on a display.

Thus, power storage system 9 can confirm whether or not battery pack 1 is the same individual unit between those time points by comparing the amount of change in the battery ID at two or more arbitrary points in time. This enables power storage system 9 to guarantee the authenticity of battery pack 1 and the battery information, for example, at the time of reuse.

For example, if any of storage batteries B0 through B7 in battery pack 1 is replaced, the replaced storage battery B and the original storage battery B are highly likely to have different AC impedances, which are physical quantities unique to each storage battery B. It is therefore possible to detect unauthorized replacement of storage battery B by executing the flowchart illustrated in FIG. 14 and comparing the identification IDs. The battery pack management system therefore reduces the security risk against unauthorized replacement of storage batteries B. Since the AC impedance is a physical quantity unique to each storage battery B and cannot be rewritten, the security risk can be reduced more reliably.

Periodically executing the flow of operations illustrated in FIG. 14 updates the first identification ID and the first battery ID to reflect the electrical characteristics of storage battery B at that point in time. Stated differently, the first identification ID and the first battery ID function as an individual identifier that includes degradation information of storage battery B. Since the degradation state, which is closely related to the battery residual value information, can be included in the first identification ID and the first battery ID, the first identification ID and the first battery ID can be utilized as battery residual value information for individual identification of battery pack 1 at the time of reuse. Since the AC impedance measurement takes only a few minutes, degradation information can be acquired in a short amount of time compared to existing degradation diagnosis methods such as the charge-discharge method.

When using the first identification ID and the first battery ID at three or more arbitrary points in time, that is, when identifying an individual unit based on the time-dependent change in impedance, the flow of operations (flow of operations for setting the individual identification number) illustrated in FIG. 13 is executed a plurality of times, and a reference range (permissible amount of change in the identification ID) is set based on the plurality of acquired first identifications. When the second identification ID is not within the reference range (for example, when the amount of change in the second identification ID is greater than or equal to a certain value compared to past data), it is determined that the battery unit at the time of generating the first identification ID and the battery unit at the time of generating the second identification ID are not the same battery unit. In this method, for example, the AC impedance is measured periodically (for example, daily), data for a predetermined period (for example, several days' worth) is saved, and the battery unit can be identified by looking at the degree of change. Note that machine learning may be used for the determining of the threshold of change.

When measuring the AC impedances of a plurality of cells (a plurality of storage batteries) simultaneously during the process of setting the battery ID, the differences in AC impedances between the cells can be acquired, and if only a specific cell has a displacement different from the others, a flag can be set indicating that the cell has been replaced.

Note that the threshold for the difference may be, for example, a variation of 20% or less.

In FIG. 13 and FIG. 14 described above, examples in which the determination of whether or not an individual unit is the same is performed using the identification ID are given, but the determination method is not limited to this, and for example, the determination of whether or not an individual unit is the same may be performed using the battery ID. Operations for determining whether or not an individual unit is the same using the battery ID will be described with reference to FIG. 15 and FIG. 16. FIG. 15 is a flowchart illustrating a second example of operations (battery pack management method) for setting an ID (here, a battery ID) to the battery pack. The operations similar to those shown in the flowchart of FIG. 13 are assigned the same reference numerals, and description thereof is omitted.

As illustrated in FIG. 15, ID reading device 12 records the first battery ID generated in step S12 (S14a). ID reading device 12 records the first battery ID in any location (memory) inside or outside power storage system 9.

Operations for identifying individual storage batteries B0 through B7 will be further described with reference to FIG. 16. FIG. 16 is a flowchart illustrating a second example of operations (battery pack management method) for identifying individual storage batteries B0 through B7 of battery pack 1. The operations similar to those shown in the flowchart of FIG. 14 are assigned the same reference numerals, and description thereof is omitted or simplified.

As illustrated in FIG. 16, ID reading device 12 compares the first battery ID generated in step S12 illustrated in FIG. 15 with the second battery ID generated in step S22 (S25a). ID reading device 12 determines whether the first battery ID matches the second battery ID, or whether a difference is less than or equal to a threshold value. ID reading device 12 determines, for each storage battery B, whether the parameter of storage battery B in the first battery ID matches the parameter of storage battery B in the second battery ID, or whether a difference is less than or equal to a threshold value. The threshold value is preset and stored in ID reading device 12. Note that, since the parameters to be compared have measurement errors, ID reading device 12 may determine that a difference is less than or equal to a threshold value (for example, the IDs are the same) if there is a mismatch within ±20%, for example. The comparison (determination) in step S25a is executed for each and every storage battery B in battery pack 1.

When ID reading device 12 determines that no falsification has occurred (S27a), ID reading device 12 defines the second battery ID as the first battery ID (S28a). ID reading device 12 redefines the second battery ID as the first battery ID. ID reading device 12 updates the value of the first battery ID to the value of the second battery ID (updates to the latest ID).

In FIG. 13 and FIG. 15 described above, examples in which the battery ID is generated from AC impedance are given, but the battery ID may be generated further using other information. Operations for using external conditions (SOC and temperature) as such other information will be described with reference to FIG. 17 and FIG. 18. FIG. 17 is a flowchart illustrating a third example of operations (battery pack management method) for setting an ID (here, a battery ID and an identification ID) to battery pack 1. The ID setting is the same as in FIG. 13, but the flow of operations differs from FIG. 13 in that when generating the battery ID, the AC impedance measured using external conditions (SOC, temperature) is normalized to a value at a standard temperature and a standard SOC (for example, a SOC of 50% and a temperature of 25°C). More specifically, in FIG. 17, in addition to the operations illustrated in FIG. 13, steps S31 and S32 are executed between step S11 and step S12.

As illustrated in FIG. 17, SOC/temperature normalizer 302 acquires external conditions (SOC and temperature) (S31). SOC/temperature normalizer 302 acquires the external conditions at a first time point.

Next, SOC/temperature normalizer 302 normalizes the measured values (AC impedances) acquired in step S11 (S32). SOC/temperature normalizer 302 normalizes the AC impedances of each of storage batteries B0 through B7 measured by impedance measurement unit 2 in accordance with the external conditions at the first time point.

Next, in step S12, a first battery ID at the first time point is generated using the normalized AC impedances.

Operations for identifying individual storage batteries B0 through B7 will be further described with reference to FIG. 18. FIG. 18 is a flowchart illustrating a third example of operations (battery pack management method) for identifying individual storage batteries B0 through B7 of battery pack 1. The ID setting and identification method are the same as in FIG. 14, but the flow of operations differs from FIG. 14 in that when generating the battery ID, the AC impedance measured using external conditions (SOC, temperature) is normalized to a value at a standard temperature and standard SOC (for example, a SOC of 50% and a temperature of 25°C). More specifically, in FIG. 18, in addition to the operations illustrated in FIG. 14, steps S41 and S42 are executed between step S21 and step S22. Note that standard temperature and standard SOC are the same at the first time point and the second time point.

As illustrated in FIG. 18, SOC/temperature normalizer 302 acquires external conditions (SOC and temperature) (S41). SOC/temperature normalizer 302 acquires the external conditions at a second time point.

Next, SOC/temperature normalizer 302 normalizes the measured values (AC impedances) acquired in step S21 (S42). SOC/temperature normalizer 302 normalizes the AC impedances of each of storage batteries B0 through B7 measured by impedance measurement unit 2 in accordance with the external conditions at the second time point.

Next, in step S22, a second battery ID at the second time point is generated using the normalized AC impedances.

In this way, in the third example, the setting and identification of the battery ID are performed using the normalized impedances, which are the normalized AC impedances. This enables identification of battery pack 1 regardless of environmental changes (SOC, temperature).

Here, an example of calculating battery authentication accuracy when employing the present embodiment will be described.

FIG. 19 illustrates a distribution of variation between cell impedances of individual units.

Here we assume that the variation between cell impedances of individual units follows a normal distribution with variance $\sigma^2$ and mean $\mu$ (refer to (a) in FIG. 19). This $3\sigma$ range of the normal distribution is divided based on the following Equation 1 (refer to (b) in FIG. 19).

$$N = [3\sigma / 5LSB \times 2] \ldots (Equation\ 1)$$

Assuming the least significant bit (LSB) as the resolution of the measurement, the true value of the cell impedance and the measurement result are assumed to fall within the divided range (assumed to fall within a range of 5LSB).

Let the probability of each of N intervals into which the range is divided be denoted as pi ($1 \leq i \leq N$).

When there are two battery packs each consisting of n cells, the probability P that the cell impedances of all channels of each battery pack match is given by the following Equation 2.

[Math. 1]

15

$$P = \left( \sum_{i=1}^{N} p_i^2 \right)^n \qquad \text{... Equation 2}$$

Based on Equation 2, the following shows an example of calculating the probability that the impedances of two cells (A, B) match in a battery pack consisting of one cell (= single cell). Assuming the cell impedance follows a uniform distribution, it is treated with 3 divisions (ignoring the measurement resolution).

FIG. 20 is for explaining Calculation Example 1 and Calculation Example 2. In FIG. 20, (a) is for explaining Calculation Example 1 and (b) is for explaining Calculation Example 2.

For example, as in Calculation Example 1 (refer to (a) in FIG. 20), the probability that the impedances of single cells match in a uniform distribution of 3 intervals (N=3, n=1) is given by following Equation 3.

[Math. 2]

$$P = \left( \sum_{i=1}^{N} p_i^2 \right)^n = \left\{ \left( \frac{1}{3} \right)^2 + \left( \frac{1}{3} \right)^2 + \left( \frac{1}{3} \right)^2 \right\}^1 = \frac{1}{3} \qquad \text{... Equation 3}$$

Similarly, as in Calculation Example 2 (refer to (b) in FIG. 20), when probabilities p1 to p3 of the 3 divided intervals are respectively 1/5, 3/5, and 1/5, the probability that the impedances of single cells match (N=3, n=1) is given by following Equation 4.

[Math. 3]

$$P = \left( \sum_{i=1}^{N} p_i^2 \right)^n = \left\{ \left( \frac{1}{5} \right)^2 + \left( \frac{3}{5} \right)^2 + \left( \frac{1}{5} \right)^2 \right\}^1 = \frac{11}{25} \qquad \text{... Equation 4}$$

Next, a calculation example assuming an actual battery pack and measuring instrument will be described. FIG. 21A illustrates the $3\sigma$ range of a normal distribution divided into 8 intervals (A to H). FIG. 21B illustrates the probability distribution of A to H.

In Calculation Example 3, the probability P that the impedances of all channels of two battery packs each consisting of n=8 cells match is considered, assuming that the impedance values follow a normal distribution with $\mu$ = 10 m$\Omega$ and $3\sigma$ = 1m $\Omega$ and are measured with a measuring instrument having a resolution of LSB = 0.05 m$\Omega$.

In such a case, the distribution of the impedance values is expressed by the following Equation 5.

$$N = [3\sigma / 5LSB \times 2] = 8 \quad \text{... (Equation 5)}$$

As Equation 5 shows, the distribution can be divided into A to H intervals (see FIG. 21A). The probability distribution of A to H is as illustrated in FIG. 21B.

From the above, following Equation 6 is acquired.

[Math. 4]

$$P = \left( \sum_{i=1}^{N} p_i^2 \right)^n \fallingdotseq 3.33822E\text{-}06 \qquad \text{... Equation 6}$$

Therefore, when assigning an ID to a battery pack, it is considered that the same ID will occur in 1 out of approximately 300,000 units.

FIG. 22A illustrates the $3\sigma$ range of a normal distribution divided into 16 intervals (A to P). FIG. 22B illustrates the probability distribution of A to P.

Calculation Example 4 shows an example in which the identification rate improves with an increase in the resolution.

The LSB is increased to 0.025 mΩ, and the calculation is performed in the same manner as Calculation Example 3. Stated differently, the probability P that the impedances of all channels of two battery packs each consisting of n=8 cells match is considered, assuming that the impedance values follow a normal distribution with $\mu = 10$ mΩ and $3\sigma = 1$ mΩ and are measured with a measuring instrument having a resolution of LSB = 0.025 mΩ.

In such a case, the distribution of the impedance values is expressed by the following Equation 7.

$$N = [3\sigma / 5LSB \times 2] = 16 \ \dots \ (Equation \ 7)$$

As Equation 7 shows, the distribution can be divided into A to P intervals (see FIG. 22A). The probability distribution of A to P is as illustrated in FIG. 22B.

From the above, following Equation 8 is acquired.

[Math. 5]

$$P = \left(\sum_{i=1}^{N} p_i^2\right)^n \fallingdotseq 1.49667E\text{-}08 \qquad \dots \ Equation \ 8$$

Therefore, when assigning an ID to a battery pack, it is considered that the same ID will occur in 1 out of approximately 70,000,000 units.

Since the battery ID can be generated by combining a plurality of parameters, the actual identification rate is further improved. Furthermore, in the case of degraded batteries, the variation in impedance values is larger than that of new batteries, and therefore the identification rate is further improved.

When performing identification using the identification ID, even if the battery IDs are the same, identification is possible by comparing the unique IDs.

Other Embodiments

Although embodiments of the present disclosure have been described above, the present disclosure is not limited to the above-described embodiments.

In each of the above embodiments, a power storage system/device that is applied to batteries used in vehicles such as EVs has been described, but power storage system 9 may be applied to batteries used in any application.

The above examples of battery ID generation methods in the embodiments may be combined. For example, battery monitoring device 8 may generate battery IDs using each of the plurality of battery ID generation methods described in the embodiments, and may identify an individual battery pack using at least one of those battery IDs.

The configurations of battery monitoring device 8, ID converter 4, etc., in each of the above embodiments may be implemented by a server device.

In each of the above embodiments, elements included in battery monitoring device 8 are implemented by hardware. However, some of the elements included in battery monitoring device 8 may be implemented by executing a software program suitable for the elements. Some of the elements included in battery monitoring device 8 may be implemented by a program execution unit such as a central processing unit (CPU) or a processor reading and executing a software program recorded on a recording medium such as a hard disk or semiconductor memory.

In each of the above embodiments, processing performed by a particular processing unit may be performed by a different processing unit. For example, the division of the function blocks in the block diagrams are mere examples. A plurality of function blocks may be realized as a single function block, a single function block may be divided into a plurality of function blocks, or a portion of functions of one block may be transferred to a different function block. A plurality of function blocks which share similar functions can be processed by standalone hardware or software in parallel or time-shared. In an operation described in each of the above-described embodiments, the order of processes may be changed or processes may be performed in parallel.

SOC/temperature normalizer 302 in each of the above embodiments is not an essential element in the battery pack management system. For example, in a battery pack management system in which impedance measurement unit 2 is configured to measure impedance when a predetermined SOC and a predetermined temperature are reached, SOC/temperature normalizer 302 may be omitted from the battery pack management system.

In each of the above embodiments, ID converter 4 may generate the battery ID using values acquired by calculating values of circuit parameters of each of storage batteries B0 through B7. ID converter 4 may, for example, generate a battery ID by arranging values acquired by adding or averaging values of circuit parameters of adjacent storage batteries B.

The battery pack management system according to the above embodiments may be implemented as a single device or by a plurality of devices. When the battery pack management system is implemented by a plurality of devices, the elements included in the battery pack management system may be distributed among the plurality of devices in any manner. When the battery pack management system is implemented by a plurality of devices, the communication method between the plurality of devices is not particularly limited, and may be wireless or wired communication. Moreover, a combination of wired and wireless communication may be used between devices.

Each element described in the above embodiments may be implemented as software, and typically, may be implemented as an LSI, which is an integrated circuit. These elements may be integrated into individual chips, or a portion or all of the elements may be integrated into one chip. Although the term LSI is used here, depending on the degree of integration, it may also be referred to as an IC, system LSI, super LSI, or ultra LSI. Circuit integration methods are not limited to LSI; the elements may be implemented using dedicated circuits (general-purpose circuits that execute dedicated programs) or a general-purpose processor. A field programmable gate array (FPGA) which allows programming after manufacturing of the LSI circuits or a reconfigurable processor which allows reconfiguration of the connections or settings of circuit cells inside the LSI circuits may be used. Furthermore, if a new technology for circuit integration that replaces LSI emerges due to advances in semiconductor technology or other derived technologies, it goes without saying that the elements may be integrated using that technology.

A system LSI circuit is ultra-multifunctional LSI circuit manufactured by integrating a plurality of processing units on a single chip, and specifically, is a computer system including a microprocessor, read only memory (ROM), random access memory (RAM), and the like. The ROM stores a computer program. The microprocessor operates according to the computer program, thereby enabling the system LSI circuit to achieve its functionality.

One aspect of the present disclosure may be a computer program that causes a computer to execute each of the characteristic steps included in any of the battery pack management methods illustrated in FIG. 13 through FIG. 18.

For example, the program may be a program for causing a computer to execute instructions. One aspect of the present disclosure may be a computer-readable non-transitory recording medium on which such a program is recorded. For example, such a program may be recorded on the recording medium and distributed or circulated. For example, by installing the distributed program on a device having another processor and causing that processor to execute the program, it becomes possible to cause that device to perform each of the above-described processes.

Embodiments arrived at by a person skilled in the art making various modifications to any one of the embodiments, or embodiments realized by arbitrarily combining elements and functions in the embodiments which do not depart from the essence of the present disclosure are also included in the present disclosure.

[Industrial Applicability]

The present disclosure is applicable in systems or the like that manage a battery pack.

[Reference Signs List]

1 battery pack
2 impedance measurement unit
3 impedance table creator (calculator)
4 ID converter (generator)
5 SOC measurement unit (measurement unit)
6 thermistor group
7 temperature measurement unit (measurement unit)
8 battery monitoring device
9 power storage system (battery pack management system)
10 communicator
11 unique ID display
12 ID reading device (generator, determination unit)
301 model parameter expander
302 SOC/temperature normalizer
303 normalized impedance table creator
B0, B1, B2, B3, B4, B5, B6, B7 storage battery
C1, C2 capacitive element

I current
L inductor
S1 communication line
R0, R1, R2 resistor
T temperature
Vn voltage
Zb0, Zb1, Zb2, Zb3, Zb4, Zb5, Zb6, Zb7 AC impedance

**Claims**

1. A battery pack management system that manages a battery pack of storage batteries connected in series or parallel, the battery pack management system comprising:

   a first acquisition unit configured to acquire respective first impedances of the storage batteries corresponding to a first time point; and
   a generator that generates first identification information of the battery pack based on the first impedances of the storage batteries acquired.

2. The battery pack management system according to claim 1, further comprising:

   a calculator that calculates a first circuit parameter in each of equivalent circuit models respectively corresponding to the storage batteries, based on the first impedances, wherein
   the generator generates the first identification information of the battery pack based on the first circuit parameters of the storage batteries calculated.

3. The battery pack management system according to claim 2, further comprising:

   a second acquisition unit configured to acquire a state of charge of the battery pack, wherein
   the calculator includes a first normalizer that normalizes the first impedances of the storage batteries with respect to the state of charge, and calculates the first circuit parameters of the storage batteries based on the first impedances of the storage batteries normalized with respect to the state of charge.

4. The battery pack management system according to claim 2 or 3, further comprising:

   a third acquisition unit configured to acquire a temperature of the battery pack, wherein
   the calculator includes a second normalizer that normalizes the first impedances of the storage batteries with respect to the temperature, and calculates the first circuit parameters of the storage batteries based on the first impedances of the storage batteries normalized with respect to the temperature.

5. The battery pack management system according to any one of claims 2 to 4, wherein

   the first circuit parameter includes a plurality of parameters, and
   the first identification information includes at least one parameter among the plurality of parameters for each of the storage batteries.

6. The battery pack management system according to any one of claims 2 to 5, wherein

   the first acquisition unit is configured to acquire respective second impedances of the storage batteries corresponding to a second time point later than the first time point,
   the calculator calculates a second circuit parameter in each of the equivalent circuit models respectively corresponding to the storage batteries, based on the second impedances of the storage batteries acquired,
   the generator generates the first identification information of the battery pack corresponding to the second time point, based on the second circuit parameters of the storage batteries calculated, and
   the battery pack management system further comprises a determination unit configured to determine whether the battery pack is a same individual unit by comparing the first identification information corresponding to the first time point and the first identification information corresponding to the second time point.

**7.** The battery pack management system according to claim 6, wherein
when the determination unit determines that the battery pack is the same individual unit, the generator updates identification information of the battery pack to the first identification information corresponding to the second time point.

**8.** The battery pack management system according to any one of claims 2 to 7, wherein
the generator generates third identification information by associating the first identification information with second identification information that is assigned in advance to each of the storage batteries and is different from the first identification information.

**9.** The battery pack management system according to claim 8, wherein

the first acquisition unit is configured to acquire respective second impedances of the storage batteries corresponding to a second time point later than the first time point,
the calculator calculates a second circuit parameter in each of the equivalent circuit models respectively corresponding to the storage batteries, based on the second impedances of the storage batteries acquired,
the generator generates one of the first identification information or the third identification information of the battery pack corresponding to the second time point, based on the second circuit parameters of the storage batteries calculated, and
the battery pack management system further comprises a determination unit configured to determine whether the battery pack is a same individual unit by comparing the one of the first identification information or the third identification information corresponding to the first time point and the one of the first identification information or the third identification information corresponding to the second time point.

**10.** The battery pack management system according to claim 9, wherein
when the determination unit determines that the battery pack is the same individual unit, the generator updates identification information of the battery pack to the one of the first identification information or the third identification information corresponding to the second time point.

**11.** The battery pack management system according to any one of claims 8 to 10, wherein
the second identification information is a barcode.

**12.** The battery pack management system according to any one of claims 8 to 10, wherein
the second identification information is a two-dimensional code.

**13.** The battery pack management system according to any one of claims 8 to 10, wherein
the second identification information is a serial number.

**14.** The battery pack management system according to any one of claims 1 to 13, further comprising:
a communicator that outputs the first identification information to an external device.

**15.** The battery pack management system according to claim 3, wherein
the first normalizer calculates the state of charge based on a full charge capacity (FCC) of the battery pack and a change in charge amount of the battery pack due to charging or discharging.

**16.** The battery pack management system according to claim 3, wherein
the first normalizer estimates the state of charge based on a relationship between state of charge and open circuit voltage.

**17.** The battery pack management system according to any one of claims 3, 15, and 16, further comprising:
a measurement unit configured to measure the state of charge of the battery pack.

**18.** The battery pack management system according to claim 4, further comprising:
a measurement unit configured to measure the temperature of the battery pack.

**19.** The battery pack management system according to any one of claims 1 to 18, further comprising:

the battery pack; and

an impedance measurement unit configured to measure respective impedances of the storage batteries.

20. The battery pack management system according to any one of claims 2 to 13, 15, 16, and 18, wherein the generator generates the first identification information by arranging values of the first circuit parameters of the storage batteries in an order of arrangement of the storage batteries.

21. A battery pack management method of managing a battery pack of storage batteries connected in series or parallel, the battery pack management method comprising:

acquiring respective impedances of the storage batteries corresponding to a first time point; and
generating identification information of the battery pack based on the impedances of the storage batteries acquired.

## FIG. 1

EP 4 492 533 A1

# FIG. 2

EP 4 492 533 A1

# FIG. 3A

4

| ID converter | | | | | | | | |
|---|---|---|---|---|---|---|---|---|
| ID value | | | | | | | | |
| R10(0) | R10(1) | R10(2) | R10(3) | R10(3) | R10(4) | R10(5) | R10(6) | R10(7) |

# FIG. 3B

4

| ID converter | | |
|---|---|---|
| ID value | | |
| R10(0), R11(0) | R10(1), R11(1) | . . . . . . . . . R10(7), R11(7) |

# FIG. 4A

Storage battery AC impedance measurement results

# FIG. 4B

Storage battery equivalent circuit and model parameters

Equivalent circuit for n = 2

I    terminals/wiring
II   electrolyte
III  negative electrode
IV  positive electrode/diffusion

# FIG. 4C

Relational expression of AC impedance
and model parameters

$$Z = j\omega L + R_0 + \sum_{i=1}^{n} \frac{R_i}{1+j\omega C_i R_i}$$

# FIG. 5A

Coulomb counting method

Obtain used charge amount (coulombs) by integrating battery current, calculate SOC from known FCC

$Q$ (charge amount) = $I$ (current) × $t$ (time)

FCC

FCC = full charge capacity (battery capacity (Ah) at full charge)

# FIG. 5B

Estimation from SOC-OCV curve

Measure or estimate OCV, estimate SOC
from known SOC-OCV curve

Pre-obtained SOC-OCV (storage battery voltage in resting state)

SOC = state of charge (ratio of remaining battery capacitance (Ah) to battery capacitance (Ah) at full charge)

OCV = open circuit voltage (battery voltage in state where current is not flowing through battery and polarization inside battery has converged)

# FIG. 6A

(a)

One example of temperature dependence
of Nyquist plot

Low
temperature
Normal
temperature
High
temperature

Normalization by
Arrhenius equation

Normalization by
Arrhenius equation

Imaginary part (mΩ)

Real part (mΩ)

Normalization

(b)

Imaginary part (mΩ)

Real part (mΩ)

(a)
Temperature-dependent
actual measurement data

(b)
Temperature-dependent
actual measurement data

FIG. 7

FIG. 8

EP 4 492 533 A1

FIG. 9

EP 4 492 533 A1

EP 4 492 533 A1

# FIG. 10

# FIG. 11A

Reading via smartphone camera

# FIG. 11B

Reading via smartphone camera

# FIG. 11C

Reading via manual input

FIG. 12

EP 4 492 533 A1

# FIG. 13

```
        ( START )
            │
            ▼                           S11
┌─────────────────────────────────────┐
│ Measure AC impedances of all cells in│
│ battery pack                         │
└─────────────────────────────────────┘
            │
            ▼                           S12
┌─────────────────────────────────────┐
│ Generate array value = first battery ID of│
│ battery pack by combining AC impedances│
└─────────────────────────────────────┘
            │
            ▼                           S13
┌─────────────────────────────────────┐
│ Obtain first unique IDs assigned per battery│
└─────────────────────────────────────┘
            │
            ▼                           S14
┌─────────────────────────────────────┐
│ Associate first battery ID with first unique│
│ IDs to form first identification ID, record│
│ first battery ID and first identification ID│
└─────────────────────────────────────┘
            │
            ▼
         ( END )
```

# FIG. 14

START

Measure AC impedance of all cells in battery pack ⟋S21

Generate array value = second battery ID of battery pack by combining AC impedance values ⟋S22

Obtain second unique IDs assigned per battery ⟋S23

Associate second battery ID with second unique IDs to form second identification ID ⟋S24

Compare first identification ID and second identification ID ⟋S25

Difference ≤ threshold value? ⟋S26   No

Yes

Determine that no falsification has occurred from time of setting individual identification number to time of individual identification ⟋S27a

Determine that falsification has occurred from time of setting individual identification number to time of individual identification ⟋S27b

Define second battery ID as first battery ID and second identification ID as first identification ID ⟋S28

Output determination result ⟋S29

END

# FIG. 15

```
           ( START )
                │            S11
                ▼        ╱
┌──────────────────────────────────────┐
│  Measure AC impedances of all cells in │
│  battery pack                          │
└──────────────────────────────────────┘
                │            S12
                ▼        ╱
┌──────────────────────────────────────┐
│  Generate array value = first battery ID of │
│  battery pack by combining AC impedances │
└──────────────────────────────────────┘
                │            S14a
                ▼        ╱
┌──────────────────────────────────────┐
│         Record first battery ID        │
└──────────────────────────────────────┘
                │
                ▼
            ( END )
```

# FIG. 16

START

Measure AC impedance of all cells in battery pack ⟋S21

Generate array value = second battery ID of battery pack by combining AC impedance values ⟋S22

Compare first battery ID and second battery ID ⟋S25a

Difference ≤ threshold value? ⟋S26 — No

Yes

Determine that no falsification has occurred from time of setting individual identification number to time of individual identification ⟋S27a

Determine that falsification has occurred from time of setting individual identification number to time of individual identification ⟋S27b

Define second battery ID as first battery ID ⟋S28a

Output determination result ⟋S29

END

# FIG. 17

START

S11

Measure AC impedances of all cells in battery pack

S31

Obtain external conditions (temperature, SOC, etc.)

S32

Normalize measured values

S12

Generate array value = first battery ID of
battery pack by combining AC impedances

S13

Obtain first unique IDs assigned per battery

S14

Associate first battery ID with first unique IDs to
form first identification ID, record first battery ID
and first identification ID

END

## FIG. 18

START

**S21**
Measure AC impedance of all cells in battery pack

**S41**
Obtain external conditions (temperature, SOC, etc.)

**S42**
Normalize measured values

**S22**
Generate array value = second battery ID of battery pack by combining AC impedance values

**S23**
Obtain second unique IDs assigned per battery

**S24**
Associate second battery ID with second unique IDs to form second identification ID

**S25**
Compare first identification ID and second identification ID

**S26**
Difference ≤ threshold value?

No →

Yes ↓

**S27a**
Determine that no falsification has occurred from time of setting individual identification number to time of individual identification

**S27b**
Determine that falsification has occurred from time of setting individual identification number to time of individual identification

**S28**
Define second battery ID as first battery ID and second identification ID as first identification ID

**S29**
Output determination result

END

## FIG. 19

Distribution of variation between cell impedances of individual units

(a)

(b)

Divide into N intervals
Number of divisions
influences resolution

$p_{i-1}$   $p_i$   $p_{i+1}$

$p_1$   $p_N$

$\mu - 3\sigma$     $\mu - 5LSB$   $\mu$   $\mu + 5LSB$     $\mu + 3\sigma$

# FIG. 20

(a)

Calculation Example 1

Probability that impedances of
single cells match in uniform
distribution of 3 intervals (N=3, n=1)

$p_1 = 1/3 \quad p_2 = 1/3 \quad p_3 = 1/3$

(b)

Calculation Example 2

Probability that impedances of
single cells match in below
distribution of 3 intervals (N=3, n=1)

$p_1 = 1/5 \quad p_2 = 3/5 \quad p_3 = 1/5$

# FIG. 21A

Calculation Example 3

# FIG. 21B

# FIG. 22A

Calculation Example 4

A B C D E F G H I J K L M N O P

$\mu - 3\sigma$　　　$\mu - \sigma$　$\mu$　$\mu + \sigma$　　　$\mu + 3\sigma$

9 mΩ　　　　　10 mΩ　　　　　11 mΩ

# FIG. 22B

Probability distribution

| | A B C D E F G H I J K L M N O P |
|---|---|
| 0.16 | |
| 0.14 | |
| 0.12 | |
| 0.1 | |
| 0.00 | |
| 0.01 | |
| 0.02 | |
| 0 | |

# INTERNATIONAL SEARCH REPORT

International application No.

**PCT/JP2022/036382**

## A. CLASSIFICATION OF SUBJECT MATTER

***H01M 10/48***(2006.01)i
FI: H01M10/48 P

According to International Patent Classification (IPC) or to both national classification and IPC

## B. FIELDS SEARCHED

Minimum documentation searched (classification system followed by classification symbols)

H01M10/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| A | JP 2021-106128 A (TOYO SYSTEM CO LTD) 26 July 2021 (2021-07-26) entire text, all drawings | 1-21 |
| A | JP 2006-33970 A (FUJI HEAVY IND LTD) 02 February 2006 (2006-02-02) entire text, all drawings | 1-21 |

☐ Further documents are listed in the continuation of Box C.    ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2022** | **22 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/036382**

| Patent document cited in search report | | | Publication date (day/month/year) | Patent family member(s) | | | Publication date (day/month/year) |
|---|---|---|---|---|---|---|---|
| JP | 2021-106128 | A | 26 July 2021 | EP | 3926727 | A1 | |
| | | | | entire text, all drawings | | | |
| | | | | KR 10-2021-0135281 | | A | |
| JP | 2006-33970 | A | 02 February 2006 | (Family: none) | | | |

Form PCT/ISA/210 (patent family annex) (January 2015)

**REFERENCES CITED IN THE DESCRIPTION**

**Patent documents cited in the description**

- JP 2013170862 A